(19) Europäisches Patentamt
European Patent Office
Office européen des brevets

(11) **EP 4 286 435 A1**

(12) **EUROPEAN PATENT APPLICATION**
published in accordance with Art. 153(4) EPC

(43) Date of publication:
06.12.2023 Bulletin 2023/49

(21) Application number: 22745984.9

(22) Date of filing: 27.01.2022

(51) International Patent Classification (IPC):
C08G 18/08 (2006.01)     C08G 18/10 (2006.01)
C08G 18/42 (2006.01)     B24B 37/24 (2012.01)
H01L 21/304 (2006.01)

(52) Cooperative Patent Classification (CPC):
B24B 37/24; C08G 18/08; C08G 18/10;
C08G 18/42; H01L 21/304

(86) International application number:
PCT/JP2022/003132

(87) International publication number:
WO 2022/163765 (04.08.2022 Gazette 2022/31)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(30) Priority: 29.01.2021 JP 2021012697

(71) Applicant: Tokuyama Corporation
Shunan-shi, Yamaguchi 745-8648 (JP)

(72) Inventors:
• FUKUDA, Kazuishi
Shunan-shi, Yamaguchi 745-8648 (JP)
• SHIMIZU, Yasutomo
Shunan-shi, Yamaguchi 745-8648 (JP)
• KAWASAKI, Takayoshi
Shunan-shi, Yamaguchi 745-8648 (JP)

(74) Representative: Beckmann, Claus
Kraus & Weisert
Patentanwälte PartGmbB
Thomas-Wimmer-Ring 15
80539 München (DE)

(54) **NOVEL CURABLE COMPOSITION CONTAINING CYCLIC MONOMER**

(57) The curable composition of the present invention contains (A) a cyclic monomer having both a polymerizable functional group and an ionic functional group in the molecule and (B) a polymerizable monomer having a polymerizable functional group capable of being polymerized with the polymerizable functional group of the cyclic monomer (A). The present invention can provide a curable composition that has easy handleability becoming a cured article that has high abrasion resistance and enhanced hydrophilicity without impairing the mechanical characteristics, and particularly can provide a curable composition becoming a cured article that can be favorably used as a polishing pad.

EP 4 286 435 A1

**Description**

Technical Field

The present invention relates to a novel cyclic monomer having both an ionic functional group forming a cation or an anion and a polymerizable functional group, and a novel curable composition containing the cyclic monomer.

Background Art

A polishing member is a material that is used in flattening an opposing member (polishing target material) with an abrasive. Specifically, the polishing member is used in flattening the surface of the polishing target material by bringing into contact with the surface while sliding with an abrasive, such as a slurry, fed thereto. Examples thereof include a polishing pad.

A polyurethane resin has been frequently used as the polishing member. In general, a material that has good abrasion resistance for a prolonged period of time and high durability is demanded for the polishing member in view of the cost reduction, the stable production, and the enhancement of the productivity.

The polishing member is used specifically as a pad material in the chemical mechanical polishing (CMP) method (which may be hereinafter referred to as a polishing pad). The CMP method is a polishing method capable of imparting an excellent surface flatness, and has been used particularly in the production processes of a liquid crystal display (LCD), a glass substrate for a hard disk, a silicon wafer, and a semiconductor device.

The CMP method generally uses a method of polishing with a slurry (polishing liquid) having abrasive grains dispersed in an alkali solution or an acid solution, which is supplied in polishing. In this method, the polishing target material is flattened through the mechanical action of the abrasive grains in the slurry and the chemical action of the alkali solution or the acid solution. In general, the surface of the polishing target material is flattened by supplying the slurry to the surface of the polishing target material, and sliding and bringing the polishing pad into contact with the surface.

The demanded polishing characteristics of the polishing pad in the CMP method include an excellent flatness of the polishing target material and a large polishing rate. Furthermore, the enhancement of the abrasion resistance is also demanded for the enhancement of the productivity.

The known materials for the polishing pad include a resin obtained by curing a urethane-based curable composition (see PTL 1).

PTL 2 discloses a polishing pad that is enhanced in retentivity of the slurry and enhanced in polishing characteristics, by enhancing the hydrophilicity of the resin used in the polishing pad (see PTL 2). PTL 2 describes that the excellent polishing characteristics are exhibited by using a polyol having a hydrophilic group (such as an ionic functional group) as one component of the urethane-based curable composition.

PTL 3 discloses that a polishing pad obtained by using a polyrotaxane monomer having both a polymerizable functional group and an ionic functional group shows excellent abrasion resistance, water absorbability, and excellent polishing pad characteristics (see PTL 3).

Citation List

Patent Literatures

PTL 1: JP 2007-77207 A
PTL 2: JP 2007-276061 A
PTL 3: WO 2020/096010

Summary of Invention

Technical Problem

In recent years, however, there is a demand of the further enhancement of the capabilities, in particular, a polishing pad that has easy handleability in production, excellent abrasion resistance, and excellent mechanical characteristics, and there is room for improvement in the ordinary techniques.

Specifically, the polishing pad described in PTL 2 uses a diol compound as a polyol compound used, and the polyurethane resin obtained by curing is insufficient in characteristics, such as the abrasion resistance. Furthermore, the polyurethane resin uses a diol compound having a low molecular weight, and thereby it is considered that the hydrophilic group introduced to the polyurethane resin for enhancing the hydrophilicity highly likely exists in the vicinity of the hard segment of the polyurethane resin. Consequently, there is a possibility that a sufficient effect of imparting hydrophilicity cannot be exhibited, and thus there is room for improvement.

The polishing pad described in PTL 3 uses a polyrotaxane monomer, which tends to have a high molecular weight due to the peculiar structure thereof, as a result, there is room for improvement for poor handleability, limited production and the like.

Accordingly, an object of the present invention is to provide a curable composition that has easy handleability becoming a cured article that has high abrasion resistance and enhanced hydrophilicity without impairing the mechanical characteristics. In particular, an object thereof is to provide a curable composition capable of becoming a cured article (for example, a polyurethane resin) that can be favorably used as a polishing pad.

Solution to Problem

The present inventors have made earnest investigations for solving the problem. As a result of the investigations made by the present inventors for solving the problem, it has been found that the use of a curable composition containing a cyclic monomer having both a polymerizable functional group and an ionic functional group in the molecule can provide good handleability, and can also provide a cured article having excellent mechanical characteristics through curing thereof, and thus the present invention has been completed.

Specifically, a first aspect of the present invention is a curable composition containing a cyclic monomer (A) having both a polymerizable functional group and an ionic functional group in the molecule and a polymerizable monomer (B) having a polymerizable functional group capable of being polymerized with the polymerizable functional group of the cyclic monomer (A).

In the first aspect of the present invention, it is preferred that the polymerizable functional group of the cyclic monomer (A) is at least one kind of a group selected from the group consisting of a radical polymerizable group, an epoxy group, a hydroxy group, a thiol group, a primary amino group, and a secondary amino group, and the ionic functional group of the cyclic monomer (A) is a group capable of forming at least one kind of an ion selected from the group consisting of a carboxylate ion, a sulfonate ion, a phosphate ion, a phosphonate ion, and a quaternary ammonium cation.

A second aspect of the present invention is a cured article obtained by curing the curable composition of the first aspect of the present invention.

The resulting cured article can be favorably used as a polishing pad.

A third aspect of the present invention is a cyclic monomer (A) having a cyclic molecules having both a polymerizable functional group and an ionic functional group.

The present invention relates to the following [1] to [11].

[1] A curable composition containing (A) a cyclic monomer having both a polymerizable functional group and an ionic functional group in the molecule and (B) a polymerizable monomer having a polymerizable functional group capable of being polymerized with the polymerizable functional group of the cyclic monomer (A).

[2] The curable composition according to [1] above, in which the polymerizable functional group of the cyclic monomer (A) is at least one kind of group selected from the group consisting of a radical polymerizable group, an epoxy group, a hydroxy group, a thiol group, a primary amino group, and a secondary amino group, and the ionic functional group of the cyclic monomer (A) is a group capable of forming at least one kind of an ion selected from the group consisting of a carboxylate ion, a sulfonate ion, a phosphate ion, a phosphonate ion, and a quaternary ammonium cation.

[3] The curable composition according to [1] or [2] above, in which the cyclic monomer (A) has a proportion of the ionic functional group of 1% by mol or more and less than 90% by mol assuming that the total molar proportion of the polymerizable functional group and the ionic functional group is 100% by mol.

[4] The curable composition according to any one of [1] to [3] above, in which the cyclic monomer (A) comprises a cyclic molecule comprising a side chain, the side chain having the polymerizable functional group and the ionic functional group and introduced as a substituent of a hydroxy group of the cyclic molecule.

[5] The curable composition according to any one of [1] to [4] above, in which the polymerizable functional group of the cyclic monomer (A) is at least one kind of a group selected from the group consisting of a hydroxy group, a thiol group, a primary amino group, and a secondary amino group, and the polymerizable monomer (B) contains (B1) an iso(thio)cyanate compound having at least an iso(thio)cyanate group in the molecule.

[6] The curable composition according to [5] above, in which the polymerizable functional group of the cyclic monomer (A) contains at least a hydroxy group, and the iso(thio)cyanate compound (B1) contained in the polymerizable monomer (B) contains (B12) a urethane prepolymer having iso(thio)cyanate groups on both end thereof, obtained through reaction of (B32) a bifunctional active hydrogen-containing compound having two active hydrogen-containing groups in the molecule, and (B13) a bifunctional polyiso(thio)cyanate compound having two iso(thio)cyanate groups in the molecule.

[7] The curable composition according to [6] above, in which the urethane prepolymer (B12) has an iso(thio)cyanate equivalent of 300 to 5,000.

[8] The curable composition according to any one of [1] to [7] above, in which the curable composition further contains (D) hollow particles having an outer shell part and a hollow part surrounded by the outer shell part, the outer shell part containing a urethane-based resin.

[9] A cured article obtained by curing the curable composition according to any one of [1] to [8] above.

[10] A polishing pad including the cured article according to [9] above.

[11] (A) a cyclic monomer comprising both a polymerizable functional group and an ionic functional group in the molecule.

Advantageous Effects of Invention

The curable composition of the present invention has good handleability, and a cured article obtained by curing the curable composition has excellent mechanical characteristics, particularly high abrasion resistance. Furthermore, the cured article is excellent in hydrophilicity. Accordingly, the cured article that is used as a sliding member, for example, a polishing pad, has good abrasion resistance. Furthermore, the cured article has excellent polishing characteristics. Specifically, the cured article can be a polishing pad that can exhibit a polishing rate, a low scratch damage, and a high flatness.

Description of Embodiment

The curable composition of the present invention is a curable composition containing (A) a cyclic monomer having both a polymerizable functional group and an ionic functional group in the molecule (which may be hereinafter referred simply to as a "cyclic monomer (A)" or a "component (A)") and (B) a polymerizable monomer having a polymerizable functional group capable of being polymerized with the polymerizable functional group (i.e., the polymerizable functional group of the cyclic molecule) of the cyclic monomer (A) (which may be hereinafter referred simply to as a "polymerizable monomer (B)" or a "component (B)"). The cyclic monomer (A) will be described.

<Cyclic Monomer (A), Component (A)>

The cyclic monomer (A) used in the present invention is not particularly limited, as far as the monomer is a cyclic molecule having both a polymerizable functional group and an ionic functional group. Examples of the cyclic molecule include a cyclodextrin, a crown ether, a benzocrown, a dibenzocrown, a dicyclohexanocrown, cyclobis(paraquat-1,4-phenylene), a dimethoxypillararene, a calixarene, a calixresorcinarene, and phenanthroline, in which a cyclodextrin and a calixarene are preferred, and a cyclodextrin is most preferred.

The cyclodextrin includes an $\alpha$-type (inner diameter of ring: 0.45 to 0.6 nm), a $\beta$-type (inner diameter of ring: 0.6 to 0.8 nm), and a $\gamma$-type (inner diameter of ring: 0.8 to 0.95 nm). A mixture thereof may also be used. In the present invention, $\alpha$-cyclodextrin and $\beta$-cyclodextrin are preferred, and $\beta$-cyclodextrin is most preferred in view of the cost and the properties.

The calixresorcinarene is a cyclic molecule obtained through ring condensation reaction of resorcinol and various aldehydes. The resorcinol herein is not limited to resorcinol, but a resorcinol derivative, such as 2-nitroresorcinol, may also be used. The aldehyde used may be any of known aldehydes with no limitation, and examples thereof include an aliphatic aldehyde, such as n-butanal, isobutanal, and heptanal, and an aromatic aldehyde, such as benzaldehyde, vanillin, and 4-nitrobenzaldehyde, two or more kinds of which may be used as a mixture. Among these, heptanal, benzaldehyde, and vanillin are preferably used. In the present invention, the calixresorcinarene is preferably a tetramer, but is not limited thereto.

The cyclic monomer (A) has a polymerizable functional group and an ionic functional group introduced thereto. While these functional groups may be bonded directly to the cyclic molecule, it is preferred that a side chain is introduced to the cyclic molecule, and the polymerizable functional group and the ionic functional group are introduced to the side chain, particularly to the end of the side chain. In more detail, the cyclic monomer (A) preferably has multiple side chain introduced thereto, and the multiple side chains preferably include a side chain having the polymerizable functional group at the end thereof and a side chain having the ionic functional group at the end thereof.

The side chain introduced to the cyclic molecule will be described.

The side chain can be introduced, for example, by using a reactive functional group of the cyclic molecule and modifying the reactive functional group (that is, the side chain can be introduced through reaction with the reactive functional group).

Examples of the reactive functional group include a hydroxy group and an amino group, in which a hydroxy group is preferred. Accordingly, the cyclic monomer (A) is preferably a cyclic monomer having a side chain introduced to the hydroxy group of the cyclic molecule having the hydroxy group, and the side chain preferably has the polymerizable functional group and the ionic functional group.

For example, a β-cyclodextrin ring has 21 hydroxy groups as reactive functional groups, and the side chain is introduced through reaction with the hydroxy group. Consequently, 21 side chains at most can be introduced to one β-cyclodextrin ring.

In the present invention, at least 3 side chains are preferably introduced for sufficiently exhibiting the function of the side chain described above. A cyclic molecule having 5 or more side chains introduced thereto is preferred, a cyclic molecule having 7 or more side chains introduced thereto is more preferred, and a cyclic molecule having 8 or more side chains introduced thereto is most preferred. While the upper limit thereof is not particularly limited, there is a concern that a too large number thereof introduced increases the viscosity of the cyclic monomer (A), deteriorating the handleability thereof. Therefore, it is particularly preferred that 8 to 18 side chains are introduced.

The cyclic monomer (A) preferably constituted only by the cyclic molecule and 3 or more side chains introduced to the cyclic molecule. The 3 or more side chains preferably include a side chain having a polymerizable functional group introduced to the end thereof and a side chain having an ionic functional group introduced to the end thereof. The 3 or more side chains preferably include only a side chain having a polymerizable functional group introduced to the end thereof and a side chain having an ionic functional group introduced to the end thereof.

The side chain is not particularly limited, and is preferably constituted by repetition of an organic chain having 3 to 20 carbon atoms. The side chain of this type preferably has a number average molecular weight, for example, of 300 or more. In more detail, the number average molecular weight of the side chain of this type may be in a range of 300 to 10,000, preferably 350 to 5,000, more preferably 400 to 5,000, and most preferably 400 to 1,500. The number average molecular weight within the range can facilitate the regulation of the hardness and the properties of the resulting cured article. The number average molecular weight of the side chain can be regulated by the amount thereof used in introducing the side chain, and can be obtained by calculation and also by the $^1$H-NMR measurement.

In the case where the lower limit of the number average molecular weight of the side chain is as described above, excellent mechanical characteristics can be exhibited to provide a tendency that the polishing rate is enhanced in using the cured article obtained by curing the curable composition of the present invention as a polishing pad. Furthermore, there is a tendency that the compatibility thereof with the polymerizable monomer (B) is enhanced. In the case where the upper limit of the number average molecular weight of the side chain is as described above, there is a tendency that the hardness of the cured article is not lowered, and the abrasion resistance thereof is also not lowered.

While the details are described later, the reactive functional group (for example, a hydroxy group) of the cyclic molecule has lower reactivity than the hydroxy group of the side chain. Therefore, the problems including the decrease in compatibility and the bleed-out unlikely occur even though the modification degree is low.

In the case where a hydroxy group corresponds to the polymerizable functional group in the present invention, the following assumption is made. For example, in the case where the cyclic molecule is a cyclodextrin, the hydroxy group of the cyclodextrin that has no side chain introduced thereto is assumed to be the polymerizable functional group. In the case where side chains are bonded to 9 hydroxy groups among 21 hydroxy groups of β-cyclodextrin, the modification degree (introduction degree) thereof is 43%.

In the present invention, the side chain may be either linear or branched, as far as the molecular weight thereof is in the range described above. For the introduction of the side chain performed, the methods and the compounds disclosed in WO 2015/159875 can be appropriately used. Specifically, ring-opening polymerization; radical polymerization; cation polymerization; anion polymerization; living radical polymerization, such as atom transfer radical polymerization, RAFT polymerization, and NMP polymerization; and the like may be used. A side chain having an appropriate size can be introduced according to the method described above through reaction of the appropriately selected compound to the reactive functional group of the cyclic molecule.

For example, a side chain derived from a cyclic compound, such as a lactone and a cyclic ether, can be introduced by ring-opening polymerization. For example, a side chain introduced by ring-opening polymerization of a cyclic compound, such as a lactone and a cyclic ether, consequently introduces a hydroxy group as the polymerizable functional group as a group having active hydrogen at the end of the side chain.

In the cyclic compounds above, a cyclic ether and a lactone are preferably used from the standpoint of the favorable availability, the high reactivity, and the easiness in regulating the size (molecular weight) thereof. For preferred examples of the cyclic ether and the lactone, reference may be made to WO 2015/159875.

The cyclic compound may be used alone, or multiple kinds thereof may be used in combination.

In the present invention, the cyclic compound capable of introducing the side chain that is preferably used is a lactone, in which a lactone, such as ε-caprolactone, α-acetyl-γ-butyrolactone, α-methyl-γ-butyrolactone, γ-valerolactone, and γ-butyrolactone, is particularly preferred, and ε-caprolactone is most preferred.

In the case where the side chain is introduced through reaction by ring-opening reaction of the cyclic compound, there may be a case where the reactive functional group (such as a hydroxy group) bonded to the cyclic molecule has poor reactivity, and the large molecule is difficult to react directly therewith particularly due to steric hindrance. In this case, for reacting the cyclic compound, such as ε-caprolactone, a method may be used in which a low molecular weight compound, such as propylene oxide, is reacted in advance with the reactive functional group to perform hydroxypropylation, so that a functional group (such as a hydroxy group) having rich reactivity is introduced, and thereafter, the side chain is introduced through the ring-opening reaction using the cyclic compound described above. In this case, the hydropropylated portion can also be assumed to be the side chain.

In alternative, a side chain having a group having active hydrogen as the polymerizable functional group can be introduced by introducing a side chain derived from a cyclic compound, such as a cyclic acetal, a cyclic amine, a cyclic carbonate, a cyclic imino ether, and a cyclic thiocarbonate, through ring-opening reaction. For specific examples of the preferred cyclic compound among these, for example, reference may be made to WO 2015/068798.

A method of introducing the side chain to the cyclic molecule through radical polymerization may also be used. There may be a case where the cyclic molecule does not have an active moiety becoming a radical starting point. In this case, an active moiety becoming a radical starting point may be formed through reaction of a compound for forming a radical starting point with the functional group (such as a hydroxy group) of the cyclic molecule, in advance of the reaction with a radical polymerizable compound.

Representative examples of the compound for forming a radical starting point include an organic halogen compound. Examples thereof include 2-bromoisobutyl bromide, 2-bromobutyric acid, 2-bromopropionic acid, 2-chloropropionic acid, 2-bromoisobutyric acid, epichlorohydrin, epibromohydrin, and 2-chloroethyl isocyanate. The organic halogen compound is bonded to the functional group of the cyclic molecule through the reaction with the functional group of the cyclic molecule, and thereby the group containing a halogen atom (i.e., the organic halogen compound residual group) to the cyclic molecule. In radical polymerization, the organic halogen compound residual group forms a radical through migration of the halogen atom or the like, and the radical polymerization proceeds with the radical as the radical polymerization starting point.

The group having an active moiety becoming a radical polymerization starting point (such as the organic halogen compound residual group) can also be introduced in such a manner that a compound having a functional group, such as an amine, an isocyanate, and an imidazole, is reacted, for example, with a hydroxy group of the cyclic molecule, so as to introduce a functional group other than a hydroxy group, and then the organic halogen compound described above is reacted with the functional group.

For the radical polymerizable compound used for introducing the side chain through radical polymerization, preferably used is a compound having at least one kind of a group having an ethylenic unsaturated bond, such as a (meth)acrylate group, a vinyl group, and a styryl group, (which may be hereinafter referred to as an ethylenic unsaturated monomer). The ethylenic unsaturated monomer used may be an oligomer or a polymer having an end ethylenic unsaturated bond. As the ethylenic unsaturated monomer, for specific examples of the preferred ethylenic unsaturated monomer, the compounds described in WO 2015/068798 can be used.

<Cyclic Monomer (A), Polymerizable Functional Group (Polymerizable Functional Group on Side Chain)>

The cyclic monomer (A) necessarily has a polymerizable functional group. The polymerizable functional group is not particularly limited, as far as the group is bonded directly or indirectly to the cyclic molecule constituting the cyclic monomer, and is preferably introduced to the cyclic molecule via the side chain for obtaining a cured article having better effects. Specifically, after introducing the side chain in the aforementioned method, the functional group of the side chain may be used as the polymerizable functional group, or the functional group of the side chain may be modified to another polymerizable functional group.

In the present invention, the reaction of introducing the structure derived from another compound through reaction of the functional group of the side chain with the compound may be referred to as "modification". The compound used for the modification is not particularly limited, as far as the compound can be reacted with the functional group of the side chain. Various polymerizable functional groups can be introduced to the side chain, and the functional group can be modified to a group having no polymerizability, by selecting the compound used for the modification.

As understood from the aforementioned description, the side chain introduced to the cyclic molecule may have various functional groups.

Furthermore, depending on the kind of the functional group of the compound used for introducing the side chain, a part of the side chain may be bonded to the functional group on the ring of the cyclic molecule of another axle molecule, so as to form a crosslinked structure.

<Preferred Polymerizable Functional Group of Cyclic Monomer (A), and Number Thereof>

The polymerizable functional group of the cyclic monomer (A) is not particularly limited. In the present invention, the polymerizable functional group of the cyclic monomer (A) is preferably at least one kind of a group selected from the group consisting of a radical polymerizable group, an epoxy group, a hydroxy group, a thiol group, a primary amino group ($-NH_2$), and a secondary amino group (NHR, wherein R represents a substituent, such as an alkyl group). Examples of the radical polymerizable group include a (meth)acrylate group, a vinyl group, and an allyl group. The (meth)acrylate means one or both of an acrylate and a methacrylate.

Among these, a hydroxy group is most preferred. In the case where the end of the side chain introduced in reacting the reactive functional group of the cyclic molecule is a hydroxy group, the hydroxy group may be used directly as the polymerizable functional group. In the case where the cyclic molecule originally has a hydroxy group, the hydroxy group may be used directly as the polymerizable functional group. In consideration of the reactivity and the like, it is preferred to use the polymerizable functional group (such as a hydroxy group) at the end of the side chain.

The number of the polymerizable functional group of the cyclic monomer (A) is not particularly limited. The cyclic monomer (A) preferably has at least 2 polymerizable functional groups for exhibiting the excellent effect in the resin as the matrix.

The polymerizable functional group is the group on the cyclic molecule or the group on the side chain introduced to the cyclic molecule. In consideration of the reactivity, the polymerizable functional group preferably exists at the end of the side chain. The cyclic monomer (A) preferably has two or more polymerizable functional groups introduced to the end of the side chain. The upper limit of the number of the polymerizable functional group is not particularly limited. The number thereof is preferably a number providing a molar number of the polymerizable functional group introduced to the end of the side chain of 0.1 mmol/g to 10 mmol/g with respect to the weight average molecular weight (Mw) of the cyclic monomer (A). This value is obtained by dividing the molar number of the polymerizable functional group introduced to the end of the side chain by the weight average molecular weight (Mw) of the cyclic monomer (A), and thus means the molar number of the polymerizable functional group introduced to the end of the side chain per 1 g of the cyclic monomer (A).

The molar number of the polymerizable functional group introduced to the end of the side chain is more preferably 0.2 mmol to 8 mmol/g. The molar number of the polymerizable functional group introduced to the end of the side chain is particularly preferably 0.5 mmol to 5 mmol/g. The weight average molecular weight is a value that is measured by gel permeation chromatography (GPC) described in detail later.

The molar number of the total polymerizable functional groups of the polymerizable functional group that is not introduced to the side chain (such as the polymerizable functional group of the cyclic molecule) and the polymerizable functional group introduced to the side chain is preferably in the following ranges. Specifically, the molar number of the total polymerizable functional groups with respect to the weight average molecular weight (Mw) of the cyclic monomer (A) is preferably 0.2 mmol to 20 mmol/g. The molar number of the total polymerizable functional groups is more preferably 0.4 mmol to 16 mmol/g, and particularly preferably 1 mmol to 10 mmol/g. The total polymerizable functional groups include, for example, the polymerizable functional group of the cyclic molecule having no side chain introduced thereto (specifically, an unmodified hydroxy group having no side chain introduced thereto of a cyclodextrin.

The molar numbers of the polymerizable functional group described above each are an average value.

<Cyclic Monomer (A), Ionic Functional Group (Ionic Functional Group on Side Chain)>

The cyclic monomer (A) necessarily has an ionic functional group. The ionic functional group is not particularly limited, as far as the group is bonded directly or indirectly to the cyclic molecule constituting the cyclic monomer, and is preferably introduced to the cyclic molecule via the side chain for providing a cured article having better effects. The case where the ionic functional group is on the end of the side chain is particularly preferred. While the method of introducing the ionic functional group is not particularly limited, it is preferred that after introducing the side chain in the aforementioned method, the functional group of the side chain is modified to the ionic functional group.

In the present invention, the ionic functional group means a group having a moiety becoming a cation or an anion, and examples thereof include a group capable of forming at least one kind of an ion selected from the group consisting of a carboxylate ion, a sulfonate ion, a phosphate ion, a phosphonate ion, and a quaternary ammonium cation. Specific examples thereof include a carboxy group or a carboxylate group (i.e., a group of a salt of a carboxy group), a sulfonic group or a sulfonate group (i.e., a group of a salt of a sulfonic group), a phosphoric group or a phosphate group (i.e., a group of a salt of a phosphoric group), a phosphonic group or a phosphonate group (i.e., a group of a salt of a phosphonic group), and a quaternary ammonium cation group or a quaternary ammonium salt group, and a sulfonic group is preferred.

In the present invention, the method of introducing the ionic functional group to the cyclic molecule is not particularly limited. One example of the introducing method will be described below. While having been described above, the ionic functional group can be introduced to the cyclic monomer (A) by any method other than the following introducing method.

<Example of Introduction of Ionic Functional Group (including Salt Group Thereof)>

For introducing a carboxy group and a sulfonic group, ring-opening reaction of an acid anhydride can be used. For example, in the case where the cyclic molecule has a hydroxy group as the reactive functional group (the cyclic molecule may directly have the hydroxy group, or the side chain introduced to the cyclic molecule may have the hydroxy group), a carboxy group can be introduced by reacting an acid anhydride with the hydroxy group. Similarly, a sulfonic acid can be introduced by reacting a sultone compound with the hydroxy group.

Specific examples of the acid anhydride compound include succinic anhydride, butylsuccinic anhydride, decylsuccinic anhydride, 2-dodecen-1-ylsuccinic anhydride, 2,2-dimethylsuccinic anhydride, hexadecylsuccinic anhydride, 2-hexen-1-ylsuccinic anhydride, isooctadecylsuccinic anhydride, isooctadecenylsuccinic anhydride, (2-methyl-2-propenyl)succinic anhydride, octadecylsuccinic anhydride, 2-octenylsuccinic anhydride, n-octylsuccinic anhydride, (2,7-octadien-1-yl)succinic anhydride, tetradecenylsuccinic anhydride, tetradecylsuccinic anhydride, tetrapropenylsuccinic anhydride, dodecylsuccinic anhydride, glutaric anhydride, 3,3-dimethylglutaric anhydride, 2,2-dimethylglutaric anhydride, 3-methylglutaric anhydride, 1,4-dioxan-2,6-dione, maleic anhydride, and phthalic anhydride.

A carboxy group can be introduced to the cyclic molecule by reacting the acid anhydride compound and the hydroxy group of the cyclic molecule. The carboxy group may be further reacted (neutralized) to form a carboxylate group.

Specific examples of the sultone compound include 1,3-propanesultone and 1,4-butanesultone.

A sulfonic group can be introduced to the cyclic molecule by reacting the sultone compound and the hydroxy group of the cyclic molecule. The sulfonic group may be further reacted (neutralized) to form a sulfonate group.

A phosphoric group, a phosphonic group, and a quaternary ammonium cation group can be introduced, for example, by forming an ester bond or an amide bond.

For example, in the case where the cyclic molecule has a hydroxy group as the reactive group (the cyclic molecule may directly have the hydroxy group, or the side chain introduced to the cyclic molecule may have the hydroxy group), the ionic functional group can be introduced via an ester bond by using a compound containing a carboxy group or a group of an acid chloride (such as -COCl group) in addition to the ionic group.

Specific examples of the compound containing a carboxy group and a group of an acid chloride and also containing the ionic functional group include the following. For introducing a phosphoric group or a phosphonic group, examples thereof include 4-phosphonobutyric acid, glycine-N,N-bis(methylenesulfonic acid), 2-phosphonobutane-1,2,4-tricarboxylic acid, 3-phosphonopropionic acid, and phosphoserine. For introducing a quaternary ammonium salt or a quaternary ammonium cation, examples thereof include N,N-dipropylalanine, N,N-dimethyl-$\beta$-alanine hydrochloride, 1-(ethoxycarbonyl)isonipecotic acid, 1-formynoisonipecotic acid, betaine anhydride, carnitine hydrochloride, and carnitine.

In the case where the cyclic molecule has a carboxy group as the reactive group (the cyclic molecule may directly have the carboxy group, or the side chain introduced to the cyclic molecule may have the carboxy group), a compound having a hydroxy group or an amino group in the molecule and also having the ionic functional group may be reacted with the carboxy group or the carboxylate group.

Specific examples of the compound containing a hydroxy group or an amino group and also containing the ionic functional group include the following.

Examples thereof include alendronic acid, 4-hydroxymethyl-2,6,7-trioxa-1-phosphabicyclo[2.2.2]octane 1-oxide, (1-aminoethyl)phosphonic acid, phosphorylethanolamine, N,N-dimethylethanolamine, N,N-dimethylpropanolamine, N,N-dimethylisopropanolamine, N,N,-diisopropylethanolamine, 4-dimethylamino-1-butanol, 6-dimethylamino-1-hexanol, dimethylaminoneopentanol, N'-(2-hydroxyethyl)-N,N,N'-trimethylethylenediamine, 5-diethylamino-1-pentanol, 4-methylpiperazine-1-ethanol, 1-(2-hydroxyethyl)piperazine, 3,3-diaminoethanol-methyldipropylamine, N,N-diethylaminopropylamine, N,N-diethylaminoethylamine, N,N-dimethylethylenediamine, N,N-dimethylaminopropylamine, N,N-diethyl-1,4-diaminopentane, N,N-dibutyl-1,3-diaminopropane, N,N-diethyl-N'-methylethylenediamine, N,N-dibutylethylenediamine, N,N-dimethylneopentanediamine, N,N-bis[3-(dimethylamino)propyl]amine, N,N,N'-trimethylethylenediamine, N-(2-aminoethyl)piperazine, 1-butylpiperazine, 1-ethylpiperazine, 1-methylpiperazine, 1-isopropylpiperazine, 1-(2-methoxyethyl)piperazine, $\beta$-methylcholine iodide, choline chloride, choline bromide, bis(2-hydroxyethyl)dimethylammonium chloride, bethanechol chloride, carbamylcholine chloride, and trimethylacetohydrazide ammonium chloride.

In the present invention, the ionic functional group of the cyclic monomer (A) may be neutralized to form a salt structure. In this case, for example, in the case where an iso(thio)cyanate compound is used as the polymerizable monomer (B), the reactivity can be controlled.

Particularly preferred examples of the ionic functional group of the cyclic molecule of the cyclic monomer (A) include a carboxy group, a sulfonic group, a quaternary ammonium salt group, and a quaternary ammonium cation group. A sulfonic group is most preferred.

The number of the ionic functional group of the cyclic monomer (A) is not particularly limited. In particular, the number thereof is preferably 0.01 to 1.0 mmol/g, and more preferably 0.05 to 0.5 mmol/g, with respect to the weight average molecular weight (Mw) of the cyclic monomer (A). A too large amount of the ionic functional group may provide a tendency that the mechanical strength of the cured article is lowered. On the other hand, a too small amount of the ionic functional group may provide a tendency that the effect of exhibiting hydrophilicity is lowered. This value is obtained by dividing the molar number of the ionic functional group of the cyclic molecule by the weight average molecular weight (Mw) of the cyclic monomer (A), and thus means the molar number of the ionic functional group per 1 g of the cyclic monomer (A). As a matter of course, the molar number of the ionic functional group is an average value.

The ionic functional group is the group on the cyclic molecule or the group introduced to the cyclic molecule by using the side chain depending on cases. In consideration of the effect of the ionic group, it is preferred that the ionic functional group exists at the end of the side chain, and the number thereof satisfies the range described above.

(Numbers of Polymerizable Functional Group and Ionic Functional Group)

The cyclic monomer (A) in the present invention has the polymerizable functional group and the ionic functional group introduced to the cyclic molecule. It is preferred that the cyclic molecule has the polymerizable functional group and the ionic functional group via a side chain. It is most preferred that the polymerizable functional group and the ionic functional group is at the ends of the side chains.

In the cyclic monomer (A), the ratio of the polymerizable functional group and the ionic functional group is preferably a proportion of the ionic functional group of 1% by mol or more and less than 90% by mol assuming that the total molar proportion of the polymerizable functional group and the ionic functional group is 100% by mol. In consideration of the balance of the properties of the resulting cured article, the proportion of the ionic functional group is more preferably 2% by mol or more and 35% by mol or less, and further preferably 2% by mol or more and 25% by mol or less.

The proportion of the polymerizable functional group herein is the proportion of the total polymerizable functional groups of the cyclic molecule. For example, in the case where the cyclic molecule is a cyclodextrin, and the polymerizable functional group is a hydroxy group, the total molar number of the hydroxy group on the cyclic molecule that is not modified with the side chain and the hydroxy group introduced to the side chain is the molar number of the polymerizable functional group (i.e., the molar number of the total polymerizable functional groups) above. Accordingly, the aforementioned description can be read as follows. The ratio of the total polymerizable functional groups and the ionic functional group is preferably a proportion of the ionic functional group of 1% by mol or more and less than 90% by mol assuming that the total molar proportion of the total molar number of the total polymerizable functional groups and the ionic functional group is 100% by mol. In consideration of the balance of the properties of the resulting cured article, the proportion of the ionic functional group is more preferably 2% by mol or more and 35% by mol or less, and further preferably 2% by mol or more and 25% by mol or less.

However, the polymerizable functional group that is not modified with the side chain may have poor reactivity in some cases, as described above. Accordingly, in the case where the molar number of the polymerizable functional group introduced to the side chain is targeted, for obtaining the cured article having excellent properties, the proportion of the ionic functional group is more preferably 2% by mol or more and 90% by mol or less, further preferably 3% by mol or more and 60% by mol or less, and particularly preferably 4% by mol or more and 40% by mol or less, assuming that the total molar proportion of the polymerizable functional group introduced to the side chain and the ionic functional group introduced to the side chain is 100% by mol.

The molar proportion of the ionic functional group in the total molar number of the polymerizable functional group and the ionic functional group introduced to the side chain is preferably 10 to 80% by mol, and more preferably 20 to 60% by mol, from the standpoint of the enhancement of the abrasion resistance of the cured article, and the standpoint of the enhancement of the flatness of the polishing target material.

(Other Preferred Configuration of Cyclic Monomer (A))

In the present invention, the cyclic monomer (A) that is most preferably used preferably has $\beta$-cyclodextrin as the cyclic molecule. It is preferred that $\epsilon$-caprolactone is used as the cyclic molecule, which has a side chain (the side chain is a polycaprolactone chain and has a hydroxy group as the polymerizable functional group at the end thereof) introduced thereto, and the ionic functional group is introduced by modifying a part of the end hydroxy group of the side chain. The ionic functional group herein is preferably a group forming a carboxylate ion, a sulfonate ion, or a quaternary ammonium cation. In this case, after hydroxypropylating the hydroxy group of $\beta$-cyclodextrin, a polycaprolactone chain may be introduced through ring-opening polymerization.

The proportion of modification of the hydroxy group of the $\beta$-cyclodextrin ring (modification degree), the molecular weight of the side chain, and the molar numbers of the polymerizable functional group and the ionic functional group are preferably as described above.

The component (A) preferably has a certain viscosity range, and thereby excellent handleability can be imparted. The preferred viscosity range is a viscosity at 60°C of 500 mPa·s to 50,000 mPa·s, more preferably 500 mPa·s to 10,000 mPa·s, and most preferably 1,000 mPa·s to 6,000 mPa·s. The viscosity can be obtained with a rotary viscometer.

In the case where the weight average molecular weight Mw of the cyclic monomer (A) is too large, the viscosity is increased in mixing with another component, such as another polymerizable monomer (B), deteriorating the handleability. There is a tendency that the compatibility is deteriorated depending on cases. From this standpoint, the weight average molecular weight (Mw) of the cyclic monomer (A) may be 1,500 to 100,000, particularly 2,000 to 30,000, particularly preferably in a range of 2,500 to 10,000, and most preferably in a range of 3,000 to 8,000. The dispersion degree (weight average molecular weight/number average molecular weight) is preferably 1.2 or less for exhibiting the stable properties. The weight average molecular weight (Mw) and the dispersion degree are values that are measured by the GPC measurement method described in the examples later. There is a tendency that a too large molecular weight of the cyclic monomer (A) deteriorates the handleability and the compatibility as described above, and therefore the cyclic monomer (A) preferably does not form a composite with another molecule.

<(B) Polymerizable Monomer having Polymerizable Functional Group capable of being polymerized with Polymerizable Functional Group of Cyclic Monomer (A)>

In the present invention, the polymerizable monomer (B) is a compound having a group that is capable of being reacted (polymerized) with the polymerizable functional group of the cyclic monomer (A). As a matter of course the compound is a compound other than the cyclic monomer (A).
The polymerizable monomer (B) used may be any known compound, as far as the compound is a polymerizable monomer that can be polymerized with the cyclic monomer (A). Various polymerizable functional groups can be introduced to the cyclic monomer (A) as described above, and the polymerizable monomer (B) may be appropriately selected corresponding thereto. Examples thereof include the polymerizable monomers described in WO 2015/068798.
In the present invention, in the case where the polymerizable functional group of the cyclic monomer (A) has a polymerizable functional group selected from a hydroxy group, a thiol group, and an amino group (such as a primary amino group ($-NH_2$) or a secondary amino group (-NHR, in which R represents a substituent, such as an alkyl group)), the polymerizable monomer (B) preferably contains (B1) an iso(thio)cyanate compound having at least an iso(thio)cyanate group in the molecule (which may be hereinafter also referred simply to as an "iso(thio)cyanate compound (B1)" or a "component (B1)").
In the case where the polymerizable functional group of the cyclic monomer (A) is a hydroxy group, an amino group, or an iso(thio)cyanate group, (B2) an epoxy group-containing monomer having an epoxy group (which may be hereinafter also referred simply to as an "epoxy group-containing monomer (B2)" or a "component (B2)") may also be selected as the polymerizable monomer (B).
In the case where the polymerizable functional group of the cyclic monomer (A) is an iso(thio)cyanate group, the polymerizable monomer (B) may be selected from (B3) a (thi)ol compound having at least one selected from a hydroxy group and a thiol group (which may be hereinafter also referred simply to as a "(thi)ol compound (B3)" or a "component (B3)") and (B4) an amino group-containing monomer having an amino group (which may be hereinafter referred simply to as an "amino group-containing monomer (B4)" or a "component (B4)").
In the present invention, the iso(thio)cyanate group means an isocyanate group (NCO group) or an isothiocyanate group (NCS group). Accordingly, in the case where plural iso(thio)cyanate groups exist, the number of the iso(thio)cyanate groups means the total number of an isocyanate group and an isothiocyanate group.
In the present invention, the polymerizable monomer (B) may be used alone, or multiple kinds thereof may be used in combination.

<Polymerization Method, Sequential Addition Polymerization>

The curable composition of the present invention may contain another component, as far as the cyclic monomer (A) and the polymerizable monomer (B) are contained therein. For example, in the case where the polymerization reaction is sequential addition (such as polycondensation or polyaddition) polymerization, another polymerizable monomer that is not polymerized with the cyclic monomer (B) but is polymerized with the polymerizable monomer (B) may be contained, as far as the cyclic monomer (A) and the polymerizable monomer (B) are contained therein. This is because in the sequential addition polymerization, even though another polymerizable monomer that is not polymerized with the component (A) exists, the component (A), the component (B), and another polymerizable monomer that is polymerizable with the component (B) can be copolymerized, as far as the polymerizable monomer (B) that can be polymerized with the component (A) exists. A polymerizable monomer that can be polymerized with both the component (B) and the component (A) may be contained.
Examples of the sequential addition polymerization will be described in more detail. Specifically, for example, in the case where the polymerizable functional group of the cyclic monomer (A) is an active hydrogen-containing group, such as a hydroxy group, and (B1) an iso(thio)cyanate compound having an iso(thio)cyanate group is contained as the polymerizable monomer, the component (B3) and the component (B4) above may be contained. In other words, in the case where the component (B 1) that is polymerized with the component (A) is contained, the component (B3) and the component (B4) that are not polymerized with the component (A) may be contained. In the sequential addition polymerization, a cured article obtained through copolymerization of the component (A), the component (B 1), the component (B3), and the component (B4) can be obtained due to the presence of the component (B1). As a matter of course, in this case, the polymerizable monomer (B) can also contain the component (B2). The polymerizable monomer (B) may be formed of the component (B1) that can be polymerized with the component (A).

In the sequential addition polymerization, the components that are polymerized with each other (i.e., the component (A) and the polymerizable monomers) are preferably stored separately from each other until performing the polymerization.

<Polymerization Method, Chain (Radical) Polymerization>

In the case where the polymerizable functional group of the cyclic monomer (A) is a radical polymerizable group, the polymerizable monomer (B) is formed of a monomer having a radical polymerizable group. In the radical polymerization, as different from the sequential addition polymerization due to the chain polymerization, the polymerizable monomer (B) is all formed of a monomer having a radical polymerizable group. Specifically, the polymerizable monomer (B) is preferably selected from a (meth)acrylate compound having a (meth)acrylate group and an allyl compound as a component (B5) described in detail later, and is particularly preferably selected from a (meth)acrylate compound.

<Polymerization Method, Sequential Addition Polymerization and Chain (Radical) Polymerization>

While the cases of the sequential addition polymerization and the chain polymerization have been described above, the following procedure may be used in the case where both types of polymerization can be performed.

For example, in the case where the polymerizable functional group of the cyclic monomer (A) has both an active hydrogen-containing group, such as a hydroxy group, and a radical polymerizable group, the polymerizable monomer (B) may only be (B5) a (meth)acrylate compound having a (meth)acrylate group or an allyl compound, or the polymerizable monomer (B) may contain the components (B2), (B3), (B4), and (B5), as far as the iso(thio)cyanate compound (B1) is contained.

<Polymerizable Monomer (B)>

<Polymerizable Monomer for Sequential Addition Polymerization as Polymerization Method>

<Iso(thio)cyanate Compound (B1), Component (B1)>

The iso(thio)cyanate compound (B1) is a monomer having at least one kind of an isocyanate group and an isothiocyanate group. Obviously, a monomer having both an isocyanate group and an iso(thio)cyanate group may also be selected. In particular, a compound having 2 to 6 of iso(thio)cyanate groups in the molecule is preferred, a compound having 2 to 4 thereof is more preferred, and a compound having 2 thereof is further preferred.

The iso(thio)cyanate compound (B1) may be (B12) a urethane prepolymer having iso(thio)cyanate groups at the ends of the molecule (which may be hereinafter also referred simply to as a "urethane prepolymer (B12)" or a "component (B12)") prepared through reaction of (B13) a bifunctional polyiso(thio)cyanate compound having two iso(thio)cyanate groups in the molecule (which may be hereinafter also referred simply to as a "urethane prepolymer (B13)" or a "component (B 13)") and (B32) a bifunctional active hydrogen-containing compound having two active hydrogen-containing groups in the molecule (which may be hereinafter also referred simply to as a "bifunctional active hydrogen-containing compound (B32)" or a "component (B32)"), which will be described later. The urethane prepolymer (B12) used in the present invention corresponding to the iso(thio)cyanate compound may be a compound containing an unreacted iso(thio)cyanate group having been used in the art with no particular limitation.

The active hydrogen-containing group is a group selected from a hydroxy group, a thiol group, a primary amino group, and a secondary amino group (for example, -NHR, in which R preferably represents an alkyl group). Specific examples of the component (B32) include those described for the (thi)ol compound (B3) and the amino group-containing monomer (B4) described in detail later. The active hydrogen-containing group is preferably a hydroxy group or a thiol group in consideration of the reactivity. Accordingly, the component (B32) is preferably a bifunctional (thi)ol compound having two hydroxy groups, two thiol groups, or one hydroxy group and one thiol group.

The iso(thio)cyanate compound (B1) can be roughly classified, for example, into an aliphatic isocyanate, an alicyclic isocyanate, an aromatic isocyanate, an isothiocyanate compound, and the urethane prepolymer (B12). One kind of the iso(thio)cyanate compound (B 1) may be used, and multiple kinds of the compound may be used. In the case where multiple kinds of the compound are used, the total amount of the multiple kinds of the compound is designated as the basic amount thereof. Specific examples of the iso(thio)cyanate compound include the following.

Aliphatic Isocyanate, Component (B1)

Examples thereof include a bifunctional isocyanate, such as ethylene diisocyanate, trimethylene diisocyanate, tetramethylene diisocyanate, hexamethylene diisocyanate, octamethylene diisocyanate, nonamethylene diisocyanate, 2,2'-dimethylpentane diisocyanate, 2,2,4-trimethylhexamethylene diisocyanate, decamethylene diisocyanate, butene diisocyanate, 1,3-butadiene 1,4-diisocyanate, 2,4,4-trimethylhexamethylene diisocyanate, 1,6,11-trimethylundecamethylene diisocyanate, 1,3,6-trimethylhexamethylene diisocyanate, 1,8-diisocyanato-4-isocyanatomethyloctane, 2,5,7-trimethyl-1,8-diisocyanato-5-isocyanatomethyloctane, bis(isocyanatoethyl) carbonate, bis(isocyanatoethyl) ether, 1,4-butylene glycol dipropyl ether ω,ω'-diisocyanate, lysine diisocyanatomethyl ester, and 2,4,4-trimethylhexamethylene diisocyanate, (which corresponds to the bifunctional polyiso(thio)cyanate (B13) constituting the urethane prepolymer (B12) described in detail later).

Examples thereof include a monofunctional isocyanate, such as ethyl isocyanate, n-propyl isocyanate, i-propyl isocyanate, butyl isocyanate, and octadecyl isocyanate.

Alicyclic Isocyanate, Component (B1)

Examples thereof include a bifunctional isocyanate (which corresponds to the bifunctional polyiso(thio)cyanate (B13) constituting the urethane prepolymer (B12) described in detail later), such as isophorone diisocyanate, (bicyclo[2.2.1]heptan-2,5-diyl)bismethylene diisocyanate, (bicyclo[2.2.1]heptan-2,6-diyl)bismethylene diisocyanate, 2β,5α-bis(isocyanato)norbornane, 2β,5β-bis(isocyanato)norbornane, 2β,6α-bis(isocyanato)norbornane, 26,66-bis(isocyanato)norbornane, 2,6-di(isocyanatomethyl)furan, bis(isocyanatomethyl)cyclohexane, dicyclohexylmethane 4,4'-diisocyanate, 4,4-isopropylidene bis(cyclohexylisocyanate), cyclohexane diisocyanate, methylcyclohexane diisocyanate, dicyclohexyldimethylmethane diisocyanate, 2,2'-dimethyldicyclohexylmethane diisocyanate, bis(4-isocyanato-n-butylidene)pentaerythritol, dimer acid diisocyanate, 2,5-bis(isocyanatomethyl)-bicyclo[2.2.1]heptane, 2,6-bis(isocyanatomethyl)-bicyclo[2.2.1]heptane, 3,8-bis(isocyanatomethyl)tricyclodecane, 3,9-bis(isocyanatomethyl)tricyclodecane, 4,8-bis(isocyanatomethyl)tricyclodecane, 4,9-bis(isocyanatomethyl)tricyclodecane, 1,5-diisocyanatodecalin, 2,7-diisocyanatodecalin, 1,4-diisocyanatodecalin, 2,6-diisocyanatodecalin, bicyclo[4.3.0]nonane 3,7-diisocyanate, bicyclo[4.3.0]nonane 4,8-diisocyanate, bicyclo[2.2.1]heptane 2,5-diisocyanate, bicyclo[2.2.1]heptane 2,6-diisocyanate, bicyclo[2.2.2]octane 2,5-diisocyanate, bicyclo[2.2.2]octane 2,6-diisocyanate, tricyclo[5.2.1.0$^{2.6}$]decane 3,8-diisocyanate, and tricyclo[5.2.1.0$^{2.6}$]decane 4,9-diisocyanate.

Examples thereof include a polyfunctional isocyanate, such as 2-isocyanatomethyl-3-(3-isocyanatopropyl)-5-isocyanatomethylbicyclo[2.2.1]heptane, 2-isocyanatomethyl-3-(3-isocyanatopropyl)-6-isocyanatomethylbicyclo[2.2.1]heptane, 2-isocyanatomethyl-2-(3-isocyanatopropyl)-5-isocyanatomethylbicyclo[2.2.1]heptane, 2-isocyanatomethyl-2-(3-isocyanatopropyl)-6-isocyanatomethylbicyclo[2.2.1]heptane, 2-isocyanatomethyl-3-(3-isocyanatopropyl)-5-(2 - isocyanatoethyl)bicyclo[2.2.1]heptane, 2-isocyanatomethyl-3-(3-isocyanatopropyl)-6-(2-isocyanatoethyl)bicyclo[2.2.1]heptane, 2-isocyanatomethyl-2-(3-isocyanatopropyl)-5-(2-isocyanatoethyl)bicyclo[2.2.1]heptane, 2-isocyanatomethyl-2-(3-isocyanatopropyl)-6-(2-isocyanatoethyl)bicyclo[2.2.1]heptane, and 1,3,5-tris(isocyanatomethyl)cyclohexane.

Examples thereof include a monofunctional isocyanate, such as cyclohexyl isocyanate.

Aromatic Isocyanate, Component (B1)

Examples thereof include a bifunctional isocyanate (which corresponds to the bifunctional polyiso(thio)cyanate (B13) constituting the urethane prepolymer (B12) described in detail later), such as (o-, m-, or p-)xylylene diisocyanate, tetrachloro-m-xylylene diisocyanate, methylene diphenyl 4,4'-diisocyanate, 4-chloro-m-xylylene diisocyanate, 4,5-dichlor-m-xylylene diisocyanate, 2,3,5,6-tetrabromo-p-xylylene diisocyanate, 4-methyl-m-xylylene diisocyanate, 4-ethyl-m-xylylene diisocyanate, bis(isocyanatoethyl)benzene, bis(isocyanatopropyl)benzene, 1,3-bis(α,α-dimethylisocyanatomethyl)benzene, 1,4-bis(α,α-dimethylisocyanatomethyl)benzene, α,α,α',α'-tetramethylxylylene diisocyanate, bis(isocyanatobutyl)benzene, bis(isocyanatomethyl)naphthalene, bis(isocyanatomethyl)diphenyl ether, bis(isocyanatoethyl) phthalate, 2,6-di(isocyanatomethyl)furan, (o-, m-, or p-)phenylene diisocyanate, tolylene diisocyanate, ethylphenylene diisocyanate, isopropylphenylene diisocyanate, dimethylphenylene diisocyanate, diethylphenylene diisocyanate, diisopropylphenylene diisocyanate, trimethylbenzene triisocyanate, benzene triisocyanate, 1,3,5-triisocyanatomethylbenzene, 1,5-naphthalene diisocyanate, methylnaphtalene diisocyanate, biphenyl diisocyanate, 2,4-tolylene diisocyanate, 2,6-tolylene diisocyanate, 4,4'-diphenylmethane diisocyanate, 2,2'-diphenylmethane diisocyanate, 2,4'-diphenylmethane diisocyanate, 3,3'-diphenylmethane 4,4'-diisocyanate, bibenzyl 4,4'-diisocyanate, bis(isocyanatophenyl)ethylene, 3,3'-dimethoxybiphenyl 4,4'-diisocyanate, phenylisocyanatomethyl isocyanate, phenylisocyanatoethyl isocyanate, tetrahydronaphthylene diisocyanate, hexahydrobenzene diisocyanate, hexahydrodiphenylmethane 4,4'-diisocyanate, diphenyl ether diisocyanate, ethylene glycol diphenyl ether diisocyanate, 1,3-propylene glycol diphenyl ether diisocyanate, benzophenone diisocyanate, diethylene glycol diphenyl ether diisocyanate, dibenzofuran diisocyanate, carbazole diisocyanate, ethylcarbazole diisocyanate, dichlorocarbazole diisocyanate, 2,4-tolylene diisocyanate, and 2,6-tolylene diisocyanate.

Examples thereof include a polyfunctional isocyanate, such as mesitylene triisocyanate, triphenylmethane triisocyanate, polymeric MDI, naphthalene triisocyanate, diphenylmethane 2,4,4'-triisocyanate, 3-methyldiphenylmethane 4,4',6-triisocyanate, and 4-methyldiphenylmethane 2,3,4',5,6-pentaisocyanate.

Examples thereof include a monofunctional isocyanate, such as phenyl isocyanate, 3-i-propenylcumyl isocyanate, 4-methoxyphenyl isocyanate, m-tolyl isocyanate, p-tolyl isocyanate, 1-naphthyl isocyanate, and dimethylbenzyl isocyanate.

Isothiocyanate Compound, Component (B 1)

Examples thereof include a bifunctional iso(thio)cyanate compound (which corresponds to the bifunctional polyiso(thio)cyanate (B13) constituting the urethane prepolymer (B12) described in detail later), such as p-phenylene diisothiocyanate, xylylene 1,4-diisothiocyanate, and ethylidyne diisothiocyanate.

<Urethane Prepolymer (B12), Urethane (B1) Component having Iso(thio)cyanate Groups at Both Ends>

In the present invention, (B12) a urethane prepolymer having iso(thio)cyanate groups at the ends of the molecule prepared through reaction of the bifunctional polyiso(thio)cyanate compound (B13) described above and (B32) a bifunctional active hydrogen-containing compound having two active hydrogen-containing groups in the molecule may be used as the iso(thio)cyanate compound (B1) described later.

In the case where the urethane prepolymer (B12) is used, the monomers exemplified below are preferably used as the bifunctional polyiso(thio)cyanate compound (B13), while not limited. Specifically, 1,5-naphthalene diisocyanate, (o-, m-, or p-)xylylene diisocyanate, 2,4-tolylene diisocyanate, 2,6-tolylene diisocyanate, (o-, m-, or p-)phenylene diisocyanate, 2,2'-diphenylmethane diisocyanate, 2,4'-diphenylmethane diisocyanate, and 4,4'-diphenylmethane diisocyanate are preferably used. The component (B12) having iso(thio)cyanate groups at both ends can be obtained by reacting a bifunctional active hydrogen-containing compound (B32) with these compounds.

For exhibiting particularly excellent characteristics by the cured article (urethane resin) finally obtained, the urethane prepolymer (B 12) is preferably produced by using at least one kind of the bifunctional active hydrogen-containing compound (B32) having a molecular weight (number average molecular weight) of 300 to 2,000. The active hydrogen-containing group means a hydroxy group, a thiol group, a primary amino group, or a secondary amino group. Among these, the active hydrogen-containing group in the bifunctional active hydrogen-containing compound (B32) is preferably a hydroxy group and/or a thiol group in consideration of the reactivity.

The bifunctional active hydrogen-containing compound (B32) may contain another kind and different one and one having a different molecular weight in combination, as far as the bifunctional active hydrogen-containing compound (B32) having a molecular weight (number average molecular weight) of 300 to 2,000 is contained. For regulating the hardness and the like of the urethane resin finally obtained, the bifunctional active hydrogen-containing compound (B32) having the molecular weight (number average molecular weight) of 300 to 2,000 and the bifunctional active hydrogen-containing compound (B32) having the molecular weight (number average molecular weight) of 90 to 300 may be used in combination in forming the urethane prepolymer (B 12). In this case, the amount of the bifunctional active hydrogen-containing compound (B32) having a molecular weight of 90 to 300 is preferably 0 to 50 parts by mass, and the amount of the bifunctional active hydrogen-containing compound (B32) having a molecular weight of 90 to 300 is more preferably 1 to 40 parts by mass, per 100 parts by mass of the bifunctional active hydrogen-containing compound (B32) having a molecular weight of 300 to 2,000, while depending on the kinds and the amounts of the bifunctional active hydrogen-containing compounds (B32) and the bifunctional polyiso(thio)cyanate compound (B 13) used.

<Component (B12), Characteristics of Urethane Prepolymer>

The urethane prepolymer (B 12) necessarily has iso(thio)cyanate groups at both ends of the molecule. Accordingly, the urethane prepolymer (B 12) is preferably produced with the molar number ($n5$) of the iso(thio)cyanate groups in the bifunctional polyiso(thio)cyanate compound (B 13) and the molar number ($n6$) of the active hydrogen-containing groups (i.e., a hydroxy group, a thiol group, and an amino group (in which a primary amino group is counted 1 mol)) of the bifunctional active hydrogen-containing compound (B32) are in a range of $1 < (n5)/(n6) \leq 2.3$. In the case where two or more kinds of the bifunctional polyiso(thio)cyanate compounds (B13) are used, the molar number ($n5$) of the iso(thio)cyanate groups is the molar number of the iso(thio)cyanate groups of the total of the bifunctional polyiso(thio)cyanate compounds (B13). In the case where two or more kinds of the bifunctional active hydrogen-containing compounds (B32) are used, the molar number (n6) of the active hydrogen-containing groups is the molar number of the active hydrogen of the total of the active hydrogen-containing groups. Even in the case where the active hydrogen-containing group is a primary amino group, the primary amino group is counted as 1 mol. Specifically, the reaction of the second amino group (-NH) of the primary amino group requires considerable energy (in other words, the second -NH in the primary amino group is hard to react). Accordingly, even in the case where the bifunctional active hydrogen-containing compound (B32) having a primary amino group is used in the present invention, the primary amino group can be counted as 1 mol.

The iso(thio)cyanate equivalent of the urethane prepolymer (B12) can be obtained by quantitatively determining the iso(thio)cyanate group of the urethane prepolymer (B12) according to JIS K7301. The iso(thio)cyanate group can be quantitatively determined by the following back titration method. First, the resulting urethane prepolymer (B12) is dissolved in a dried solvent. Subsequently, di-n-butylamine having a known concentration in an amount that is apparently excess to the amount of the iso(thio)cyanate group of the urethane prepolymer (B12) is added to the dried solvent, so as to react the entire iso(thio)cyanate group of the urethane prepolymer (B12) with di-n-butylamine. Subsequently, di-n-butylamine that is not consumed (i.e., that does not contribute to the reaction) is titrated with an acid to determine the amount of di-n-butylamine consumed. The amount of di-n-butylamine consumed and the amount of the iso(thio)cyanate group of the urethane prepolymer (B12) are the same as each other, from which the iso(thio)cyanate equivalent can be obtained. The urethane prepolymer (B12) is a linear urethane prepolymer having iso(thio)cyanate groups at both ends thereof, and therefore the number average molecular weight of the urethane prepolymer (B12) is twice the iso(thio)cyanate equivalent. This molecular weight of the urethane prepolymer (B12) tends to conform to the value measured by gel permeation chromatography (GPC). In the case where the urethane prepolymer (B12) and the bifunctional polyiso(thio)cyanate compound (B13) are used in combination, it suffices that the mixture thereof is measured according to the aforementioned method.

The iso(thio)cyanate equivalent of the urethane prepolymer (B 12) is preferably 300 to 5,000, more preferably 350 to 3,000, and particularly preferably 350 to 2,000, while not particularly limited. The mechanism therefor is not clear, but can be considered as follows. Specifically, it is considered that the urethane prepolymer (B 12) having a certain molecular weight is reacted with the polymerizable functional group of the cyclic monomer (A), so as to increase the movement of the molecule itself, and as a result, the molecule likely recovers from deformation (elastic recovery or low hysteresis loss). Furthermore, it is considered that the use of the urethane prepolymer (B 12) facilitates the dispersion of the crosslinking points in the urethane resin, resulting in the uniform and random dispersion thereof, by which the stable capability can be exhibited. It is also considered that the urethane resin obtained by using the urethane prepolymer (B12) facilitates the control in production, and can also be favorably applied to a polishing pad. In the case where the urethane prepolymer (B 12) and the bifunctional polyiso(thio)cyanate compound (B 13) are used in combination, it is considered that these effects are exhibited even in the case where the average iso(thio)cyanate equivalent of the polyiso(thio)cyanate compound is 300 to 5,000. However, it is considered that these effects are conspicuous in the case where only the urethane prepolymer (B 12) is used.

(Production Method of Urethane Prepolymer (B12))

The urethane prepolymer (B 12) used in the present invention may be produced in such a manner that the bifunctional active hydrogen-containing compound (B32) having two active hydrogen-containing groups, such as a hydroxy group, an amino group, and a thiol group, and the bifunctional polyiso(thio)cyanate compound (B 13) may be reacted to produce the urethane prepolymer (B 12) having iso(thio)cyanate groups at both ends thereof. There is no limitation, as far as the prepolymer having iso(thio)cyanate groups at both ends thereof can be provided.

As described above, the mixing amounts of the bifunctional active hydrogen-containing compound (B32) and the bifunctional polyiso(thio)cyanate compound (B 13) that are preferred for obtaining the urethane prepolymer (B 12) is as follows. Specifically, the urethane prepolymer is preferably produced with the molar number (n5) of the iso(thio)cyanate groups in the bifunctional polyiso(thio)cyanate compound (B13) and the molar number (n6) of the active hydrogen-containing groups of the bifunctional active hydrogen-containing compound (B32) that are in a range of $1 < (n5)/(n6) \leq 2.3$.

In the reaction of the production of the urethane prepolymer (B12), heating and a urethanization catalyst may be used depending on necessity in the production.

Most preferred examples of the component (B1) used in the present invention include an alicyclic isocyanate, such as isophorone diisocyanate, 1,3-bis(isocyanatomethyl)cyclohexane, dicyclohexylmethane 4,4'-diisocyanate, and (bicyclo[2.2.1]heptan-2,5(2,6)-diyl)bismethylene diisocyanate, an aromatic isocyanate, such as 2,4-tolylene diisocyanate, 2,6-tolylene diisocyanate, 4,4'-diphenylmethane diisocyanate, and (o-, m-, or p-)xylylene diisocyanate, a polyfunctional isocyanate having a burette structure, a uretodione structure, or an isocyanurate structure, formed with a diisocyanate compound, such as hexamethylene diisocyanate and tolylene diisocyanate, as a major raw material, a polyfunctional isocyanate as an adduct with a trifunctional or higher functional polyol, and the urethane prepolymer (B12), from the standpoint of the strength of the resulting resin and the control of the reactivity.

The component (B1) that is preferred in the use of the present invention as a polishing pad is the urethane prepolymer (B12). The use of the urethane prepolymer (B12) can provide the favorable resin properties. The urethane prepolymer (B12) formed of an aromatic isocyanate is particularly preferred, and the urethane prepolymer formed of 2,4-tolylene diisocyanate or 2,6-tolylene diisocyanate is most preferred.

<Epoxy Group-containing Monomer (B2), Component (B2)>

The epoxy group-containing monomer has an epoxy group as a polymerizable group in the molecule thereof, and is preferred particularly in the case where a hydroxy group, an amino group, or an iso(thio)cyanate group is introduced as the polymerizable functional group of the cyclic monomer (A).

The epoxy compound can be roughly classified, for example, into an aliphatic epoxy compound, an alicyclic epoxy compound, and an aromatic epoxy compound, and for preferred specific examples thereof, reference may be made to WO 2015/068798.

<(Thi)ol Compound (B3), Component (B3)>

The (thi)ol compound is a compound that has two or more of a group selected from the group consisting of a hydroxy group and a thiol group in one molecule. A compound having two groups of a hydroxy group and a thiol group is also included.

The (thi)ol compound can be roughly classified into an aliphatic alcohol, an alicyclic alcohol, an aromatic alcohol, a polyester polyol, a polyether polyol, a polycaprolactone polyol, a polycarbonate polyol, a polyacrylic polyol, a castor oil-based polyol, a thiol, and a hydroxy group type or thiol group type polymerizable group-containing compound. Specific examples thereof include the following.

Aliphatic Alcohol, Component (B3)

Examples thereof include a bifunctional polyol, such as ethylene glycol, diethylene glycol, propylene glycol, dipropylene glycol, butylene glycol, 1,5-dihydroxypentane, 1,6-dihydroxyhexane, 1,7-dihydroxyheptane, 1,8-dihydroxyoctane, 1,9-dihydroxynonane, 1,10-dihydroxydecane, 1,11-dihydroxyundecane, 1,12-dihydroxydodecane, neopentyl glycol, glyceryl monooleate, monoelaidin, polyethylene glycol, 3-methyl-1,5-dihydroxypentane, dihydroxyneopentyl, 2-ethyl-1,2-dihydroxyhexane, and 2-methyl-1,3-dihydroxypropane, (which corresponds to the bifunctional active hydrogen-containing compound (B32) constituting the urethane prepolymer (B12) described above).

Examples thereof include a polyfunctional polyol, such as glycerin, trimethylolethane, trimethylolpropane, ditrimethylolpropane, trimethylolpropane polyoxyethylene ether (for example, TMP-30, TMP-60, and TMP-90, available from Nippon Nyukazai Co., Ltd.), butanetriol, 1,2-methylglucoside, pentaerythritol, dipentaerythritol, tripentaerythritol, sorbitol, erythritol, threitol, ribitol, arabinitol, xylitol, allitol, mannitol, dulcitol, iditol, glycol, inositol, hexanetriol, triglycerol, diglycerol, and triethylene glycol.

Alicyclic Alcohol, Component (B3)

Examples thereof include a bifunctional polyol, such as hydrogenated bisphenol A, cyclobutanediol, cyclopentanediol, cyclohexanediol, cycloheptanediol, cyclooctanediol, cyclohexanedimethanol, hydroxypropylcyclohexanol, tricyclo[5.2.1.0$^{2,6}$]decanedimethanol, bicyclo[4.3.0]nonanediol, dicyclohexanediol, tricyclo[5.3.1.13.9]dodecanediol, bicyclo[4.3.0]nonanedimethanol, tricyclo[5.3.1.1$^{3,9}$]dodecanediethanol, hydroxypropyltricyclo[5.3.1.1$^{3,9}$]dodecanol, spiro[3,4]octanediol, dibutylcyclohexanediol, 1,1'-bicyclohexylidenediol, 1,4-cyclohexanedimethanol, 1,3-cyclohexanedimethanol, 1,2-cyclohexanedimethanol, and o-dihydroxyxylylene, (which corresponds to the bifunctional active hydrogen-containing compound (B32) constituting the urethane prepolymer (B12) described above).

Examples thereof include a polyfunctional polyol, such as tris(2-hydroxyethyl) isocyanurate, cyclohexanetriol, sucrose, maltitol, and lactitol.

Aromatic Alcohol, Component (B3)

Examples thereof include a bifunctional polyol (which corresponds to the bifunctional active hydrogen-containing compound (B32) constituting the urethane prepolymer (B12) described above), such as dihydroxynaphthalene, dihydroxybenzene, bisphenol A, bisphenol F, xylylene glycol, tetrabromobisphenol A, bis(4-hydroxyphenyl)methane, 1,1-bis(4-hydroxyphenyl)ethane, 1,2-bis(4-hydroxyphenyl)ethane, bis(4-hydroxyphenyl)phenylmethane, bis(4-hydroxyphenyl)diphenylmethane, bis(4-hydroxyphenyl)-1-naphthylmethane, 1,1-bis(4-hydroxyphenyl)-1-phenylethane, 2-(4-hydroxyphenyl)-2-(3-hydroxyphenyl)propane, 2,2-bis(4- hydroxyphenyl)butane, 1,1-bis(4-hydroxyphenyl)butane, 2,2-bis(4-hydroxyphenyl)-3-methylbutane, 2,2-bis(4-hydroxyphenyl)pentane, 3,3-bis(4-hydroxyphenyl)pentane, 2,2-bis(4-hydroxyphenyl)hexane, 2,2-bis(4-hydroxyphenyl)octane, 2,2-bis(4-hydroxyphenyl)-4-methylpentane, 2,2-bis(4-hydroxyphenyl)heptane, 4,4-bis(4-hydroxyphenyl)heptane, 2,2-bis(4-hydroxyphenyl)tridecane, 2,2-bis(4-hydroxyphenyl)octane, 2,2-bis(3-methyl-4-hydroxyphenyl)propane, 2,2-bis(3-ethyl-4-hydroxyphenyl)propane, 2,2-bis(3-n-propyl-4-hydroxyphenyl)propane, 2,2-bis(3-isopropyl-4-hydroxyphenyl)propane, 2,2-bis(3-sec-butyl-4-hydroxyphenyl)propane, 2,2-bis(3-tert-butyl-4-hydroxyphenyl)propane, 2,2-bis(3-cyclohexyl-4-hydroxyphenyl)propane, 2,2-bis(3-allyl-4'-hydroxyphenyl)propane, 2,2-bis(3-methoxy-4-hydroxyphenyl)propane, 2,2-bis(3,5-dimethyl-4-hydroxyphenyl)propane, 2,2-bis(2,3,5,6-tetramethyl-4-hydroxyphenyl)propane, bis(4-hydroxyphenyl)cyanomethane, 1-cyano-3,3-bis(4-hydroxyphenyl)butane, 2,2-bis(4-hydroxyphenyl)hexafluoropropane, 1,1-bis(4-hydroxyphenyl)cyclopentane, 1,1-bis(4-hydroxyphenyl)cyclohexane, 1,1-bis(4-hydroxyphenyl)cycloheptane, 1,1-bis(3-methyl-4-hydroxyphenyl)cyclohexane, 1,1-bis(3,5-dimethyl-4-hydroxyphenyl)cyclohexane, 1,1-bis(3,5-dichloro-4-hydroxyphenyl)cyclohexane, 1,1-bis(3-methyl-4-hydroxyphenyl)-4-methylcyclohexane, 1,1-bis(4-hydroxyphenyl)-3,3,5-trimethylcyclohexane, 2,2-bis(4-hydroxyphenyl)norbornane, 2,2-bis(4-hydroxyphenyl)adamantane, 4,4'-dihydroxydiphenyl ether, 4,4'-dihydroxy-3,3'-dimethyldiphenyl ether, ethylene glycol bis(4-hydroxyphenyl) ether, 4,4'-dihydroxydiphenyl sulfide, 3,3'-dimethyl-4,4'-dihydroxydiphenyl sulfide, 3,3'-dicyclohexyl-4,4'-dihydroxydiphenyl sulfide, 3,3'-diphenyl-4,4'-dihydroxydiphenyl sulfide, 4,4'-dihydroxydiphenyl sulfoxide, 3,3'-dimethyl-4,4'-dihydroxydiphenyl sulfoxide, 4,4'-dihydroxydiphenyl sulfone, 4,4'-dihydroxy-3,3'-dimethyldiphenyl sulfone, bis(4-hydroxyphenyl) ketone, bis(4-hydroxy-3-methylphenyl) ketone, 7,7'-dihydroxy-3,3',4,4'-tetrahydro-4,4,4',4'-tetramethyl-2,2'-spirobi(2H-1-benzopyrane), trans-2,3-bis(4-hydroxyphenyl)-2-butene, 9,9-bis(4-hydroxyphenyl)fluorene, 3,3-bis(4-hydroxyphenyl)-2-butanone, 1,6-bis(4-hydroxyphenyl)-1,6-hexanedione, 4,4'-dihydroxybiphenyl, m-dihydroxyxylylene, p-dihydroxyxylylene, 1,4-bis(2-hydroxyethyl)benzene, 1,4-bis(3-hydroxypropyl)benzene, 1,4-bis(4-hydroxybutyl)benzene, 1,4-bis(5-hydroxypentyl)benzene, 1,4-bis(6-hydroxyhexyl)benzene, 2,2-bis[4-(2"-hydroxyethyloxy)phenyl]propane, hydroquinone, and resorcinol.

Examples thereof include a polyfunctional polyol, such as trihydroxynaphthalene, tetrahydroxynaphthalene, benzenetriol, biphenyltetraol, pyrogallol, (hydroxynaphthyl)pyrogallol, and trihydroxyphenanthrene.

Polyester Polyol, Component (B3)

Examples thereof include a compound obtained through condensation reaction of a polyol and a polybasic acid. In particular, the compound preferably has a number average molecular weight of 400 to 2,000, more preferably 500 to 1,500, and most preferably 600 to 1,200. The compound having hydroxy groups only at the end of the molecule (i.e., two hydroxy groups in the molecule) corresponds to the bifunctional active hydrogen-containing compound (B32) constituting the urethane prepolymer (B12) described above.

Examples of the polyol include ethylene glycol, 1,2-propanediol, 1,3-butanediol, 1,4-butanediol, 3-methyl-1,5-pentanediol, 1,6-hexanediol, 3,3'-dimethylolheptane, 1,4-cyclohexanedimethanol, neopentyl glycol, 3,3-bis(hydroxymethyl)heptane, diethylene glycol, dipropylene glycol, glycerin, and trimethylolpropane, which may be used alone, or as a mixture of two or more kinds thereof. Examples of the polybasic acid include succinic acid, adipic acid, azelaic acid, sebacic acid, dodecanedicarboxylic acid, cyclopentanedicarboxylic acid, cyclohexanedicarboxylic acid, orthophthalic acid, isophthalic acid, terephthalic acid, and naphthalenedicarboxylic acid, which may be used alone, or as a mixture of two or more kinds thereof.

The polyester polyol is available as a reagent or industrially available, and examples of the commercially available products thereof include "Polylite (registered trademark)" Series, available from DIC Corporation, "Nipporane (registered trademark)" Series, available from Nippon Polyurethane Industry Co., Ltd., "Maximol (registered trademark)" Series, available from Kawasaki Kasei Chemicals, Ltd., and "Kuraray Polyol (registered trademark)" Series, available from Kuraray Co., Ltd.

Polyether Polyol, Component (B3)

Examples thereof include a compound obtained through ring-opening reaction of an alkylene oxide, a compound obtained through reaction of a compound having two or more active hydrogen-containing groups in the molecule and an alkylene oxide, and a modified product thereof. In particular, the compound preferably has a number average molecular weight of 400 to 2,000, more preferably 500 to 1,500, and most preferably 600 to 1,200. The compound having hydroxy groups only at the end of the molecule (i.e., two hydroxy groups in the molecule) corresponds to the bifunctional active hydrogen-containing compound (B32) constituting the urethane prepolymer (B12) described above.

Examples of the polyether polyol include a polymer polyol, a urethane-modified polyether polyol, and a polyether ester copolymer polyol, and examples of the compound having two or more active hydrogen-containing groups in the molecule include water and a polyol compound, for example, glycol and glycerin having one or more hydroxy group in the molecule, such as ethylene glycol, propylene glycol, butanediol, glycerin, trimethylolpropane, hexanetriol, triethanolamine, diglycerin, pentaerythritol, trimethylolpropane, and hexanetriol, which may be used alone, or as a mixture of two or more kinds thereof.

Examples of the alkylene oxide include a cyclic ether, such as ethylene oxide, propylene oxide, and tetrahydrofuran, which may be used alone, or as a mixture of two or more kinds thereof.

The polyether polyol is available as a reagent or industrially available, and examples of commercially available products thereof include "Excenol (registered trademark)" Series and "Emulstar (registered trademark)", available from AGC Inc., and "Adeka Polyether (registered trademark)" Series, available from Adeka Corporation.

Polycaprolactone Polyol, Component (B3)

Examples thereof include a compound obtained through ring-opening reaction of ε-caprolactone. In particular, the compound preferably has a number average molecular weight of 400 to 2,000, more preferably 500 to 1,500, and most preferably 600 to 1,200. The compound having hydroxy groups only at the end of the molecule (i.e., two hydroxy groups in the molecule) corresponds to the bifunctional active hydrogen-containing compound (B32) constituting the urethane prepolymer (B12) described above.

The polycaprolactone polyol is available as a reagent or industrially available, and examples of commercially available products thereof include "Placcel (registered trademark)" Series, available from Daicel Corporation.

Polycarbonate Polyol, Component (B3)

Examples thereof include a compound obtained through phosgenation of one or more kinds of a low molecular polyol, and a compound obtained through ester exchange using ethylene carbonate, diethylene carbonate, diphenyl carbonate, or the like. In particular, the compound preferably has a number average molecular weight of 400 to 2,000, more preferably 500 to 1,500, and most preferably 600 to 1,200. The compound having hydroxy groups only at the end of the molecule (i.e., two hydroxy groups in the molecule) corresponds to the bifunctional active hydrogen-containing compound (B32) constituting the urethane prepolymer (B12) described above.

Examples of the low molecular weight polyol include a low molecular weight polyol compound, such as ethylene glycol, 1,2-propanediol, 1,3-propanediol, 2-methyl-1,3-propanediol, 1,2-butanediol, 1,3-butanediol, 1,4-butanediol, 1,5-pentanediol, 1,6-hexanediol, 1,8-octanediol, 1,9-nonanediol, 1,10-decanediol, 3-methyl-1,5-pentanediol, 2-ethyl-4-butyl-1,3-propanediol, diethylene glycol, dipropylene glycol, neopentyl glycol, cyclohexane-1,4-diol, cyclohexane-1,4-dimethanol, dimer acid diol, an ethylene oxide or propylene oxide adduct of bisphenol A, bis(β-hydroxyethyl)benzene, xylylene glycol, glycerin, trimethylolpropane, and pentaerythritol.

Polyacrylic Polyol, Component (B3)

Examples thereof include a polyol compound obtained through polymerization of a (meth)acrylate ester or a vinyl monomer. The compound having hydroxy groups only at the end of the molecule (i.e., two hydroxy groups in the molecule) corresponds to the bifunctional active hydrogen-containing compound (B32) constituting the urethane prepolymer (B12) described above.

Castor Oil-based Polyol, Component (B3)

Examples of the castor oil-based polyol include a polyol compound derived from a castor oil, which is a natural fat or oil, as a starting material. The compound having hydroxy groups only at the end of the molecule (i.e., two hydroxy groups in the molecule) corresponds to the component (B32) constituting the urethane prepolymer (B12) described above.

The castor oil polyol is available as a reagent or industrially available, and examples of commercially available products thereof include "URIC (registered trademark)" Series, available from Itoh Oil Chemicals Co., Ltd.

Thiol, Component (B3)

For the preferred specific examples of the thiol, the compounds described in WO 2015/068798 can be used. Among these, particularly preferred examples thereof include the following.

Examples thereof include tetraethylene glycol bis(3-mercaptopropionate), 1,4-butanediol bis(3-mercaptopropionate), 1,6-hexanediol bis(3-mercaptopropionate), and 1,4-bis(mercaptopropylthiomethyl)benzene, (which correspond to the bifunctional active hydrogen-containing compound (B32) constituting the urethane prepolymer (B12) described above).

Examples thereof include trimethylolpropane tris(3-mercaptopropionate), pentaerythritol tetrakis(3-mercaptopropionate), dipentaerythritol hexakis(3-mercaptopropionate), 1,2-bis[(2-mercaptoethyl)thio]-3-mercaptopropane, 2,2-bis(mercaptomethyl)-1,4-butanedithiol, 2,5-bis(mercaptomethyl)-1,4-dithiane, 4-mercaptomethyl-1,8-dimercapto-3,6-dithiaoctane, 1,1,1,1-tetrakis(mercaptomethyl)methane, 1,1,3,3-tetrakis(mercaptomethylthio)propane, 1,1,2,2-tetrakis(mercaptomethylthio)ethane, 4,6-bis(mercaptomethylthio)-1,3-dithiane, and tris{(3-mercaptopropionyloxy)ethyl} isocyanurate.

Hydroxy Group Type or Thiol Group Type Polymerizable Group-containing Compound, Component (B3)

Examples thereof include 2-mercaptoethanol, 1-hydroxy-4-mercaptocyclohexane, 2-mercaptohydroquinone, 4-mercaptophenol, 1-hydroxyethylthio-3-mercaptoethylthiobenzene, 4-hydroxy-4'-mercaptodiphenyl sulfone, 2-(2-mercaptoethylthio)ethanol, dihydroxyethylsulfide mono(3-mercaptopropionate), and dimercaptoethane mono(salicylate), (which correspond to the bifunctional active hydrogen-containing compound (B32) constituting the urethane prepolymer (B12) described above).

Examples thereof include a poly(thi)ol, such as 3-mercapto-1,2-propanediol, glycerin di(mercaptoacetate), 2,4-dimercaptophenol, 1,3-dimercapto-2-propanol, 2,3-dimercapto-1-propanol, 1,2-dimercapto-1,3-butanediol, pentaerythritol tris(3-mercaptopropionate), pentaerythritol mono(3-mercaptopropionate), pentaerythritol bis(3-mercaptopropionate), pentaerythritol tris(thioglycolate), pentaerythritol pentakis(3-mercaptopripionate), hydroxymethyltris(mercaptoethylthiomethyl)methane, and hydroxyethylthiomethyltris(mercaptoethylthio)methane.

<Amino Group-containing Monomer (B4), Component (B4)>

The amino group-containing monomer (B4) is a monomer having two or more primary or secondary amino groups in one molecule, which can be roughly classified into an aliphatic amine, an alicyclic amine, and an aromatic amine, and specific examples thereof include the following.

Aliphatic Amine, Component (B4)

Examples thereof include a polyamine, such as ethylenediamine, hexamethylenediamine, nonamethylenediamine, undecamethylenediamine, dodecamethylenediamine, m-xylenediamine, 1,3-propanediamine, putrescine, and diethylenetriamine.

Examples thereof include a monofunctional amine, such as monoethylamine, n-propylamine, diethylamine, di-n-propylamine, n-propylamine, di-n-butylamine, and n-butylamine.

Alicyclic Amine, Component (B4)

Examples thereof include a polyamine, such as isophoronediamine and cyclohexyldiamine.

Examples thereof include a monofunctional amine, such as cyclohexylamine and N-methylcyclohexylamine.

Aromatic Amine, Component (B4)

Examples thereof include a polyamine, such as 4,4'-methylenebis(o-chloroaniline) (MOCA), 2,6-dichloro-p-phenylenediamine, 4,4'-methylenebis(2,3-dichloroaniline), 4,4'-methylenebis(2-ethyl-6-methylaniline), 3,5-bis(methylthio)-2,4-toluenediamine, 3,5-bis(methylthio)-2,6-toluenediamine, 3,5-diethyltoluene-2,4-diamine, 3,5-diethyltoluene-2,6-diamine, trimethylene glycol di-p-aminobenzoate, polytetramethylene glycol di-p-aminobenzoate, 4,4'-diamino-3,3',5,5'-tetraethyldiphenylmethane, 4,4'-diamino-3,3'-diisopropyl-5,5'-dimethyldiphenylmethane, 4,4'-diamino-3,3',5,5'-tetraisopropyldiphenylmethane, 1,2-bis(2-aminophenylthio)ethane, 4,4'-diamino-3,3'-diethyl-5,5'-dimethyldiphenylmethane, N,N'-di-sec-butyl-4,4'-diaminodiphenylmethane, 3,3'-diethyl-4,4'-diaminodiphenylmethane, m-xylylenediamine, N,N'-di-sec-butyl-p-phenylenediamine, m-phenylenediamine, p-xylylenediamine, p-phenylenediamine, 3,3'-methylenebis(methyl-6-aminobenzoate), 2-methylpropyl 2,4-diamino-4-chlorobenzoate, isopropyl 2,4-diamino-4-chlorobenzoate, isopropyl 2,4-diamino-4-chlorophenylacetate, di(2-aminophenyl)thioethyl terephthalate, diphenylmethanediamine, tolylenediamine, piperazine, 1,3,5-benzenetriamine, and melamine.

Examples thereof include a monofunctional amine, such as benzylamine and dibenzylamine.

The diamine compound in the component (B4) can also be assumed to be (B32) a bifunctional active hydrogen-containing compound having two active hydrogen-containing groups in the molecule.

In the curable composition of the present invention, the contents of the component (A) and the component (B) are not particularly limited, and it is preferred that the content of the component (A) is 5 to 45 parts by mass, and the content of the component (B) is 55 to 95 parts by mass, based on 100 parts by mass in total of the component (A) and the component (B). It is more preferred that the content of the component (A) is 10 to 20 parts by mass, and the content of the component (B) is 80 to 90 parts by mass, based on 100 parts by mass in total of the component (A) and the component (B).

<Preferred Mixing Ratio of Polymerizable Monomer for Sequential Addition Polymerization as Polymerization Method>

Polymerizable Monomers including Component (B 1), Component (B2), Component (B3), and Component (B4)

In the present invention, the curable composition containing the component (B1), the component (B2), the component (B3), and the component (B4) preferably has the following mixing ratio. Accordingly, in the case where the polymerizable functional group of the cyclic monomer (A) is not a radical polymerizable group, but a cured article is produced by curing through sequential addition (polycondensation or polyaddition) polymerization, the following mixing ratio is preferred. In the case where the polymerizable functional group of the component (A) is an active hydrogen-containing group, the component (B1) is necessarily used.

Specifically, it is preferred that the component (A) is contained in a range of 3 to 50 parts by mass, and the component (B) is contained in a range of 50 to 97 parts by mass, based on 100 parts by mass in the total amount of the component (B 1) (including the component (B 12) and the component (B 13) in the case using them), the component (B2), the component (B3), and the component (B4) (which may be hereinafter also referred simply to as a "component (B) amount"), and the component (A). In the case where the component (A) is contained in the range, the resulting cured article can exhibit excellent polishing characteristics and mechanical characteristics in the case of a polishing pad. For exhibiting the effect, it is more preferred that the component (A) is contained in a range of 5 to 45 parts by mass, and the component (B) amount is contained in a range of 55 to 95 parts by mass.

It is preferred for exhibiting excellent mechanical characteristics that the component (B1) is 0 to 100% by mass, the component (B2) is 0 to 100% by mass, the component (B3) is 0 to 80% by mass, and the component (B4) is 0 to 30% by mass, based on 100% by mass of the component (B). For further exhibiting the effect, it is more preferred that the component (B1) is 20 to 95% by mass, the component (B2) is 0 to 20% by mass, the component (B3) is 0 to 70% by mass, and the component (B4) is 0 to 25% by mass, and it is most preferred that the component (B1) is 40 to 95% by mass, the component (B2) is 0 to 5% by mass, the component (B3) is 0 to 35% by mass, and the component (B4) is 0 to 20% by mass.

The ratio of the molar number of the total polymerizable functional group capable of reacting with the iso(thio)cyanate group contained in the component (A), the component (B2), the component (B3), and the component (B4), and the molar number of the total iso(thio)cyanate group of the component (B1) preferably satisfies 1/0.8 to 1.2.

<Polymerizable Monomer of Chain (Radical) Polymerization as Polymerization Method>

<Radical Polymerizable Monomer (B5)>

In the present invention, the radical polymerizable monomer (B5) (which may be hereinafter also referred simply to as a "component (B5)") is not particularly limited, as far as the monomer has a radical polymerizable group. In this case, the polymerizable functional group contained in the cyclic monomer (A) is a radical polymerizable group, and the polymerizable monomer (B) contains at least the component (B5).

The radical polymerizable monomer (B5) can be roughly classified into a (meth)acrylate compound having a (meth)acrylate group, a vinyl compound having a vinyl group, and an allyl compound having an allyl group.

For preferred specific examples of the radical polymerizable monomer (B5), the compounds described in WO 2015/068798 can be used.

<Preferred Curable Composition>

The cyclic monomer (A) and the polymerizable monomer (B) may be appropriately selected depending on the use. In the case where the cured article is used as a polishing pad, the polymerizable functional group of the cyclic monomer (A) is preferably selected from a hydroxy group, a thiol group, and an amino group, and the polymerizable monomer (B) preferably contains the iso(thio)cyanate compound (B1). In the case where the cured article is used as a polishing pad material, the urethane prepolymer (B12) in the iso(thio)cyanate compound (B1) is preferably contained. According to the configuration, the mechanical characteristics of the polishing pad can be enhanced, and particularly favorable abrasion resistance characteristics can be exhibited.

The curable composition of the present invention may contain a polyrotaxane monomer, but it is preferred that a polyrotaxane monomer is not used in a large amount from the standpoint of the improvement of the handleability. The content of a polyrotaxane monomer in the curable composition is preferably 10% by mass or less, more preferably 5% by mass or less, and further preferably 0% by mass.

(Other Components mixed in Curable Composition)

The curable composition of the present invention may contain various kinds of a polymerization curing accelerator (C) depending on the polymerizable functional groups introduced to the cyclic monomer (A) and the polymerizable monomer (B) for accelerating the curing thereof.

Polymerization Curing Accelerator (C)

For example, in the case where the polymerizable functional group of the cyclic monomer (A) is a polymerizable group, such as a hydroxy group, an amino group, an epoxy group, and a thiol group, and the component (B) contains the iso(thio)cyanate compound (B1), a reaction catalyst for urethane or urea (C1) and a condensation agent (C2) may be used as the polymerization curing accelerator.

In the case where the polymerizable functional group of the cyclic monomer (A) is a polymerizable functional group, such as a hydroxy group and an amino group, and the component (B) contains the epoxy group-containing monomer (B2), an epoxy curing agent (C3) and a cation polymerization catalyst (C4) for performing ring-opening polymerization of an epoxy group may be used as the polymerization curing accelerator.

In the case where the polymerizable functional group of the cyclic monomer (A) is a radical polymerizable group, and the component (B) contains the radical polymerizable monomer (B5), a radical polymerization initiator (C5) may be used as the polymerization curing accelerator.

For specific examples of the polymerization curing accelerators (C1) to (C5) preferably used in the present invention, the compounds described in WO 2015/068798 can be used.

One kind of these various polymerization curing accelerators (C) may be used alone, and two or more kinds thereof may be used in combination, and the amount thereof used may be a so-called catalytic amount, and may be, for example, a small amount in the range of 0.001 to 10 parts by mass, and particularly 0.01 to 5 parts by mass, per 100 parts by mass in total of the cyclic monomer (A) and the polymerizable monomer (B).

The curable composition of the present invention may further use the known various mixing agents in such a range that does not impair the effects of the present invention. For example, abrasive grains, an antioxidant, an ultraviolet ray absorbent, an infrared ray absorbent, a coloration inhibitor, a fluorescent dye, a dye, a photochromic compound, a pigment, a perfume, a surfactant, a flame retardant, a plasticizer, a filler, an antistatic agent, a foam stabilizer, a solvent, a leveling agent or other additives may be added. These additives may be used alone, or as a combination of two or more kinds thereof. The additives may be contained in the curable composition, and thus is contained in the cured article through polymerization of the curable composition. Specific examples of the abrasive grains include particles formed of a material selected from cerium oxide, silicon oxide, alumina, silicon carbide, zirconia, iron oxide, manganese dioxide, titanium oxide, and diamond, and two or more kinds of particles formed of these materials.

The polymerization method used may be any known method. For the sequential addition (polycondensation or polyaddition) polymerization, the conditions described in WO 2015/068798, WO 2016/143910, and JP 2017-48305A can be employed. For the chain (radical) polymerization, the conditions described in WO 2014/136804 and WO 2015/068798 can be employed.

The cured article obtained by curing the curable composition of the present invention may be formed into a foamed article by providing pores in the cured article depending on the applications. The known applications of this type include a polishing pad. The method of forming a foamed article by providing pores in the cured article for the use as a polishing pad may be any known method with no particular limitation. Examples of the method include a method of dispersing a volatile foaming agent, such as a low boiling point hydrocarbon, or fine hollow particles (microballoons), followed by curing, a method of mixing a thermally expandable fine particles and then heating to foam the fine particles, and a mechanical floss foaming method of blowing air or an inert gas, such as nitrogen, during mixing. In the case where the curable composition capable of forming a urethane bond is used for the cured article of the present invention, a foaming agent foaming method of adding water may also be used. Among these, the method of forming the cured article into a foamed article is preferably a method of dispersing fine hollow particles (microballoons), followed by curing. The fine hollow particles used in this method will be described.

Fine Hollow Particles (D)

In the present invention, the curable composition containing the component (A) and the component (B) may be further mixed with fine hollow particles (D) (which may be hereinafter also referred simply to as a "component (D)").

The component (D) used may be any known material with no particular limitation. Specifically particles having an outer shell formed of a vinylidene chloride resin, a (meth)acrylate resin, an acrylonitrile-vinylidene chloride copolymer, an epoxy resin, a phenol resin, a melamine resin, and a urethane-based resin can be used. Among these, the component (D) is preferably hollow particles including an outer shell part formed of at least one kind of a resin selected from the group consisting of a urethane-based resin and a melamine resin, and a hollow part surrounded by the outer shell part. The urethane-based resin is a resin having a urethane bond and/or a urea bond. The melamine resin is a resin produced through polycondensation of melamine and formaldehyde. The use of the component (D) facilitates the efficient production of a uniform foamed article.

The average particle diameter of the component (D) is not particularly limited, but is preferably in the following range. Specifically, the average particle diameter thereof is preferably 1 $\mu$m to 500 $\mu$m, and more preferably 5 $\mu$m to 200 $\mu$m.

The density of the component (D) is not particularly limited, but is preferably in the following range. Specifically, the density thereof is preferably 0.01 g/cm$^3$ to 0.5 g/cm$^3$, and more preferably 0.02 g/cm3 to 0.3 g/cm3. The density herein is the density of the component (D) at the time of expansion. In the case where the particles are unexpanded type, and they are the hollow particles that are mixed with the curable composition and are expanded with heat for curing, it is preferable that the density at the time of expansion is the aforementioned density.

The amount of the component (D) mixed may be appropriately determined depending on the target use. Especially, in the case where the resulting cured article is used as a polishing pad, the amount thereof mixed is preferably as follows. Specifically, the component (D) is preferably 0.1 to 20 parts by mass, more preferably 0.2 to 10 parts by mass, and further preferably 0.5 to 8 parts by mass, per 100 parts by mass in total of the component (A) and the component (B).

<Cured Article, Polishing Pad>

In the present invention, the curable composition containing the cyclic monomer (A) having both the polymerizable functional group that is an active hydrogen-containing group containing active hydrogen, and the polymerizable monomer (B) containing an iso(thio)cyanate compound (B1) having at least iso(thio)cyanate group in the molecule can be cured to obtain a urethane resin as a cured article.

The urethane resin that is a cured article obtained from the curable composition of the present invention can be used as a polishing pad due to the excellent mechanical characteristics thereof. The urethane resin can optionally have a suitable hardness. The hardness can be measured according to a Shore method, and for example, can be measured according to JIS K6253 (hardness test). The urethane resin preferably has a Shore hardness of 20A to 90D. The urethane resin used as an ordinary polishing pad in the present invention preferably has a Shore hardness of 30A to 70D, and more preferably 40A to 50D (in which "A" means a hardness of Shore "A" scale, and "D" means a hardness of Shore D scale). An optional hardness can be provided by changing the mixing formulation and the mixing amounts depending on necessity.

The urethane resin preferably has a compressibility in a certain range for exhibiting the flatness of the polishing target material. The compressibility can be measured, for example, by a method according to JIS L1096. The compressibility of the urethane-based resin is preferably 0.5% to 50%. The compressibility within the range enables the exhibition of the excellent flatness of the polishing target material.

The urethane resin used as a polishing pad can have a low hysteresis loss or an excellent elastic recovery capability, and thereby can exhibit the flatness of the polishing target material and a high polishing rate. The hysteresis loss can be measured, for example, by a method according to JIS K6251. Specifically, a test piece prepared in a dumbbell shape is stretched by 100% and then recovered, and thereby the hysteresis loss [(area of elongation and stress after stretching and recovering)/(area of elongation and stress in stretching) $\times$ 100] can be measured.

The hysteresis loss of the resulting urethane resin is preferably 60% or less, more preferably 50% or less, and further preferably 40% or less, while not limited. It is considered that with a low hysteresis loss, in the use as a polishing pad, the kinetic energy of the abrasive grains can be uniformly used for polishing the polishing target material, and thereby an excellent flatness and a high polishing rate can be obtained. It is further considered that with a low hysteresis loss, a soft pad can exhibit an excellent polishing rate. In the measurement of the hysteresis loss described above, the "area of elongation and stress after stretching and recovering" is shown by (area of stress-strain curve in stretching)-(area of stress-strain curve in compression), and the "area of elongation and stress in stretching" means (area of stress-strain curve in stretching).

In the case where the cured article obtained from the curable composition of the present invention is used as a polishing pad, the Taber abrasion amount as an index of the abrasion resistance of the cured article is preferably 60 mg or less, and more preferably 50 mg or less, in the Taber abrasion test. A small Taber abrasion amount enables excellent abrasion resistance exhibited in the use as a polishing pad. The detailed Taber test method will be described in the method shown in Examples later.

The polishing pad using the urethane resin obtained according to the present invention may have a polishing layer including multiple layers. For example, the urethane resin includes two layers, the polishing layer may be constituted by the first layer having a polishing surface brought into contact with the polishing target material in polishing, and the second layer in contact with the first layer at the surface opposite to the polishing surface of the first layer. In this case, the properties of the first layer can be regulated by the second layer having a hardness and an elastic modulus that are different from the first layer. For example, the polishability to the polishing target material can be regulated by differentiating the hardness of the first layer and the hardness of the second layer. In particular, it is preferred that both the first and second layers are cured articles obtained from the curable composition of the present invention.

In the case where the resulting urethane resin is used as a polishing pad, the following embodiment can be used. Specifically, a so-called fixed abrasive grain urethane resin containing abrasive grains inside can be formed. Examples of the abrasive grains include particles formed of a material selected from cerium oxide, silicon oxide, alumina, silicon carbide, zirconia, iron oxide, manganese dioxide, titanium oxide, and diamond, and two or more kinds of particles formed of these materials. The method of retaining the abrasive grains is not particularly limited, and for example, the abrasive grains can be retained inside the urethane-based resin (cured article) by dispersing in the curable composition and then curing the curable composition.

In the present invention, the polishing pad using the resulting urethane resin (cured articled) may have a groove structure formed on the surface thereof while not limited. In the case where the cured article is used as a polishing pad, in particular, the groove structure preferably has a shape that retains and renews the slurry in polishing a polishing target material. Specific examples thereof include X grooves (stripes), XY lattice grooves, concentric grooves, through holes, non-through holes, polygonal columns, circular cylinders, spiral grooves, eccentric grooves, radial grooves, and a combination of these grooves.

The formation method of the grooves is not particularly limited. Examples thereof include a method of mechanically cutting with a tool, such as a cutting tool, having a prescribed size, a method of casting the resin in a mold having a prescribed surface shape, followed by curing, a method of pressing the resin with a pressing plate having a prescribed surface shape, a method of forming by photolithography, a method of forming by printing, and a method of forming with laser, such as carbon dioxide laser.

In the present invention, a non-woven fabric or the like may be impregnated with the curable composition capable of forming a urethane resin (cured article), which is then cured to provide a non-woven fabric urethane resin polishing pad.

Examples of the application of the cured article obtained by curing the curable composition of the present invention include a buffering material, a damping material, and an acoustic material, in addition to the polishing pad described above. A non-woven fabric may be impregnated with the curable composition of the present invention, which is then cured to provide the non-woven fabric polishing pad described above, and also a buffering material, a damping material, and an acoustic material.

Examples

The present invention will be described in detail with reference to examples and comparative examples below, but the present invention is not limited to the examples. The measurement equipments used in the present invention and the production methods and the like of the components will be described.

(Measurement of Molecular Weight, Gel Permeation Chromatography (GPC))

The measurement with GPC was performed with a liquid chromatography apparatus (available from Nihon Waters K.K.). The columns used were appropriately selected from Shodex GPC KF-802 (exclusion limit molecular weight: 5,000), KF-802.5 (exclusion limit molecular weight: 20,000), KF-803 (exclusion limit molecular weight: 70,000), KF-804 (exclusion limit molecular weight: 400,000), and KF-805 (exclusion limit molecular weight: 2,000,000), available from Showa Denko K.K., depending on the molecular weight of the specimen. Dimethylformamide (DMF) was used as the development liquid, and the measurement was performed under condition of a flow rate of 1 mL/min and a temperature of 40°C. The standard specimen used was polystyrene, with which the weight average molecular weight was obtained through calibration. The detector used was a differential refractometer.

[Components]

Component (A-1), Cyclic Monomer A-1, Cyclic Monomer having Side Chain on Cyclic Molecule, and having Hydroxy Group as Polymerizable Functional Group and Sulfonic Group as Ionic Functional Group at Ends of Side Chain

- Weight average molecular weight Mw (GPC): 6,138
- Dispersion degree (GPC): 1.10
- Modification degree of side chain: 0.43 (43% in terms of percentage)

- Molecular weight of side chain: ca. 580 in number average molecular weight
- Content of polymerizable functional group (polymerizable functional group introduced to side chain): 1.10 mmol/g
- Content of ionic functional group (sulfonic group): 0.35 mmol/g
- Content of unreacted hydroxy group having no side chain introduced: 1.88 mmol/g
- Content of total polymerizable active group: 2.97 mmol/g
- (a) Molar proportion of ionic functional group to total molar number of polymerizable functional group and ionic functional group introduced to side chain: 22% by mol
- (b) Molar proportion of ionic functional group to total molar number of total polymerizable functional groups and ionic functional group: 10.5% by mol

Component (A-2), Cyclic Monomer A-2, Cyclic Monomer having Side Chain on Cyclic Molecule, and having Hydroxy Group as Polymerizable Functional Group and Sulfonic Group as Ionic Functional Group at Ends of Side Chain

- Weight average molecular weight Mw (GPC): 6,738
- Dispersion degree (GPC): 1.13
- Modification degree of side chain: 0.43 (43% in terms of percentage)
- Molecular weight of side chain: ca. 660 in number average molecular weight
- Content of polymerizable functional group (polymerizable functional group introduced to side chain): 0.14 mmol/g
- Content of ionic functional group (sulfonic group): 1.13 mmol/g
- Content of unreacted hydroxy group having no side chain introduced: 1.70 mmol/g
- Content of total polymerizable active group: 1.84 mmol/g
- (a) Molar proportion of ionic functional group to total molar number of polymerizable functional group and ionic functional group introduced to side chain: 88% by mol
- (b) Molar proportion of ionic functional group to total molar number of total polymerizable functional groups and ionic functional group: 42.0% by mol

Component (A-3), Cyclic Monomer A-3, Cyclic Monomer having Side Chain on Cyclic Molecule, and having Hydroxy Group as Polymerizable Functional Group and Carboxy Group as Ionic Functional Group at Ends of Side Chain

- Weight average molecular weight Mw (GPC): 6,029
- Dispersion degree (GPC): 1.11
- Modification degree of side chain: 0.43 (43% in terms of percentage)
- Molecular weight of side chain: ca. 570 in number average molecular weight
- Content of polymerizable functional group (polymerizable functional group introduced to side chain): 1.11 mmol/g
- Content of ionic functional group (carboxy group): 0.35 mmol/g
- Content of unreacted hydroxy group having no side chain introduced: 1.90 mmol/g
- Content of total polymerizable active group: 3.02 mmol/g
- (a) Molar proportion of ionic functional group to total molar number of polymerizable functional group and ionic functional group introduced to side chain: 22% by mol
- (b) Molar proportion of ionic functional group to total molar number of total polymerizable functional groups and ionic functional group: 10.5% by mol

Component (A-4), Cyclic Monomer A-4, Cyclic Monomer having Side Chain on Cyclic Molecule, and having Hydroxy Group as Polymerizable Functional Group and Phosphate Ion as Ionic Functional Group at Ends of Side Chain

- Weight average molecular weight Mw (GPC): 5,945
- Dispersion degree (GPC): 1.10
- Modification degree of side chain: 0.43 (43% in terms of percentage)
- Molecular weight of side chain: ca. 570 in number average molecular weight
- Content of polymerizable functional group (polymerizable functional group introduced to side chain): 1.13 mmol/g
- Content of ionic functional group (carboxy group): 0.35 mmol/g
- Content of unreacted hydroxy group having no side chain introduced: 1.93 mmol/g

- Content of total polymerizable active group: 3.06 mmol/g
- (a) Molar proportion of ionic functional group to total molar number of polymerizable functional group and ionic functional group introduced to side chain: 22% by mol
- (b) Molar proportion of ionic functional group to total molar number of total polymerizable functional groups and ionic functional group: 10.5% by mol

The production method of the cyclic monomer A will be described.

<Preparation Method of Cyclic Monomer A-1>

100.0 g of hydroxypropylated β-cyclodextrin (available from CycloChem Co., Ltd.) and 304.2 g of ε-caprolactone were agitated at 130°C to form a uniform solution, which was then agitated at 130°C for 5 hours under decompression to 20 kPa. Thereafter, 0.41 g of tin(II) 2-ethylhexanoate was added and reacted in a dry nitrogen atmosphere for 16 hours, and a polycaprolactone side chain-containing β-cyclodextrin having a hydroxy group at the end (end hydroxy group-containing side chain cyclodextrin (pre-A)) was collected. The properties of the product collected were as follows.

- Weight average molecular weight Mw (GPC): 4,700
- Dispersion degree (GPC): 1.06
- Modification degree of side chain: 0.43 (43% in terms of percentage)
- Molecular weight of side chain: 550 in number average molecular weight
- Viscosity: 3,800 mPa·s

20 g of the end hydroxy group-containing side chain cyclodextrin was dissolved in 40 mL of dehydrated THF, to which 0.35 g of sodium hydride was then added, and the mixture was agitated at room temperature for 2 hours. At this time, a hydroxy group of the cyclic molecule and sodium hydride were reacted to generate hydrogen. After completing the generation of hydrogen, 0.89 g of 1,3-propanesultone was added, and the mixture was agitated at room temperature for 24 hours. Thereafter, the reaction was terminated by adding 100 mL of a saturated ammonium chloride aqueous solution to the reaction liquid, which was then extracted with ethyl acetate. The resulting organic phase was distilled to remove the solvent and dried to provide a cyclic monomer A-1 having a sulfonic group. The amount of the sulfonic group introduced was conformed with a $^1$H-NMR measurement apparatus (JNM-LA500, available from JEOL, Ltd.). The content of the polymerizable functional group (hydroxy group) was calculated from the hydroxy value. The cyclic monomer A-1 had the properties described above.

<Preparation Method of Cyclic Monomer A-2>

The cyclic monomer A-2 was obtained in the same manner as in the cyclic monomer A-1 except that 1.28 g of sodium hydroxide and 3.25 g of 1,3-propanesultone were used.

<Preparation Method of Cyclic Monomer A-3>

The cyclic monomer A-3 was obtained in the same manner as in the cyclic monomer A-1 except that 0.73 g of triethylamine and 0.73 g of succinic anhydride were used instead of sodium hydroxide and 1,3-propanesultone.

<Preparation Method of Cyclic Monomer A-4>

The cyclic monomer A-4 was obtained in the same manner as in the cyclic monomer A-1 except that 1.64 g of tributylamine and 0.64 g of phosphoric acid were used instead of sodium hydroxide and 1,3-propanesultone.
The other materials used were as follows.

Component (B), Polymerizable Monomer

Component (B12), Urethane Prepolymer

Pre-1: Isocyanate-ended Urethane Prepolymer having Iso(thio)cyanate Equivalent of 905

<Production Method of Pre-1>

In a flask equipped with a nitrogen introduction tube, a thermometer, and an agitator, 50 g of 2,4-tolylene diisocyanate, 90 g of polyoxytetramethylene glycol (number average molecular weight: 1,000), and 12 g of diethylene glycol were reacted at 80°C for 6 hours, so as to provide an isocyanate-ended urethane prepolymer Pre-1 having an iso(thio)cyanate equivalent of 905.

Component (B3), (Thi)ol Compound

RX-1: Ionic Functional Group-containing Polyrotaxane Monomer

RX-1 was produced according to the method described in PTL 3.
RX-1 had the following properties.

- Weight average molecular weight Mw (GPC) of polyrotaxane: 203,000
- Modification degree of side chain: 0.5 (50% in terms of percentage)
- Molecular weight of side chain: ca. 360 in average
- Content of polymerizable functional group (polymerizable functional group introduced to side chain): 1.37 mmol/g
- Content of ionic functional group (carboxy group): 0.35 mmol/g
- Content of unreacted hydroxy group having no side chain introduced: 1.52 mmol/g
- Content of total polymerizable active group: 2.89 mmol/g
- (a) Molar proportion of ionic functional group to total molar number of polymerizable functional group and ionic functional group introduced to side chain: 9.9% by mol
- (b) Molar proportion of ionic functional group to total molar number of total polymerizable functional groups and ionic functional group: 4.9% by mol

Component (B4), Amino Group-containing Monomer

MOCA: 4,4'-Methylenebis(o-chloroaniline)

(Other Components)

Component (D), Fine Hollow Particles

Hollow Particles 1: Hollow microcapsules 920-40 (available from Japan Fillite Co., Ltd.)

Example 1

A curable composition was prepared by using the cyclic monomer A as the component (A) in the following manner.
13.6 parts by mass of the component (A-1) and 5.4 parts by mass of MOCA as the component (B4) were mixed at 120°C to form a uniform solution, which was sufficiently deaerated to provide a solution 1. The solution 1 was added to 81.0 parts by mass of Pre-1 as the component (B12) heated to 70°C, which was uniformly mixed with a planetary centrifugal mixer, so as to provide a curable composition.
Subsequently, the curable composition was cast in a mold, and cured at 100°C for 15 hours, so as to provide a cured article having a thickness of 2 mm. The cured article obtained above had a water absorption rate of 3.3%. The evaluation method is shown below.

[Evaluation Items]

(1) Measurement of Water Absorption Rate

The cured article was sufficiently dried at 100°C under reduced pressure until reaching a constant mass. Thereafter, the cured article was immersed in distilled water at 25°C for 24 hours. The water absorption rate (%) calculated from the weights of the specimen before and after the immersion according to the following expression.

$$\text{Water absorption rate } (\%) = \{[(\text{weight after immersion}) - (\text{weight before immersion})]/(\text{weight before immersion})\} \times 100$$

(2) Abrasion resistance (Taber Abrasion Amount)

The Taber abrasion amount was measured with Model 5130 equipment, available from Taber, Inc. The measurement condition was a load of 1 kg, a rotational speed of 60 rpm, and a rotation number of 1,000, with an abrasion wheel H-18.

Example 2

A cured article was produced and evaluated in the same manner as in Example 1 except that 20.3 parts by mass of the component (A-2), 5.0 parts by mass of MOCA as the component (B4), and 74.0 parts by mass of Pre-1 as the component (B12) were used.

Example 3

A cured article was produced and evaluated in the same manner as in Example 1 except that 13.4 parts by mass of the component (A-3), 5.4 parts by mass of MOCA as the component (B4), and 81.2 parts by mass of Pre-1 as the component (B12) were used.

Example 4

A cured article was produced and evaluated in the same manner as in Example 1 except that 13.2 parts by mass of the component (A-4), 5.4 parts by mass of MOCA as the component (B4), and 81.4 parts by mass of Pre-1 as the component (B12) were used.

Comparative Examples 1 and 2

Cured articles were produced and evaluated in the same manner as in Example 1 except that the curable compositions having the compositions shown in Table 1 were used. The mixing ratios of the components and the results are shown in Table 1. Comparative Example 1 is an example using the ionic functional group-containing polyrotaxane monomer (RX-1) instead of the cyclic monomer A, and Comparative Example 2 is an example using the end hydroxy group-containing side chain cyclodextrin (pre-A) having no ionic functional group instead of the cyclic monomer A.

Table 1

| | Curable composition | | Evaluation result | |
|---|---|---|---|---|
| | Component (A) (part by mass) | Component (B) (part by mass) | 24 h Water absorption rate (%) | Abrasion resistance (mg) |
| Example 1 | A-1 (13.6) | Pre-1 (81.0)/MOCA (5.4) | 3.3 | 18 |
| Example 2 | A-2 (20.3) | Pre-1 (74.0) /MOCA (5.0) | 4.1 | 39 |
| Example 3 | A-3 (13.4) | Pre-1 (81.2)/MOCA (5.4) | 3.2 | 19 |
| Example 4 | A-4 (13.2) | Pre-1 (81.4)/MOCA (5.4) | 3.2 | 19 |
| Comparative Example 1 | - | RX-1 (26.4)/Pre-1 (68.8)/ MOCA (4.8) | 3.1 | 16 |
| Comparative Example 2 | - | Pre-A (12.0)/Pre-1 (82.5) /MOCA (5.5) | 2.5 | 18 |

As shown by the results of Examples 1 to 3, the cured article obtained by curing the curable composition using the cyclic monomer having both a polymerizable functional group and an ionic functional group of the present invention showed excellent water absorption characteristics while retaining the excellent abrasion characteristics thereof. The abrasion resistance (Taber abrasion amount) of the cured article obtained from the curable composition of Example 3 was slightly inferior to the other Examples, but the value was in the allowable range. The curable compositions of Examples 1 to 3 were excellent in handleability, but the curable composition of Comparative Example 1 was poor in handleability due to the polyrotaxane monomer contained in a large amount. The water absorption rate in Comparative Example 2 was lower than Examples.

Example 5

A curable composition was prepared by using the cyclic monomer A-1 as the component (A) in the following manner.

13.6 parts by mass of the component (A-1) and 5.4 parts by mass of MOCA as the component (B4) were mixed at 120°C to form a uniform solution, which was sufficiently deaerated to provide a solution 1. Separately, 0.8 part by mass of the hollow particles 1 as other components were added to 81.0 parts by mass of Pre-1 as the component (B12) heated to 70°C, which were agitated with a planetary centrifugal mixer, so as to provide a uniform solution 2. The solution 1 was added to the solution 2 prepared above, which were uniformly mixed to provide a curable composition.

Subsequently, the curable composition was cast in a mold, and cured at 100°C for 15 hours. After completing the curing, the urethane resin was released from the mold, and sliced to provide a cured article formed of the urethane resin having a thickness of 1 mm. Spiral grooves were formed on the surface of the cured article, and a double-sided adhesive tape was adhered to the back surface thereof, so as to provide a polishing pad having a diameter of 500 mm and a thickness of 1 mm.

Example 6

A cured article and a polishing pad were produced and evaluated in the same manner as in Example 5 except that 20.3 parts by mass of the component (A-2), 5.0 parts by mass of MOCA as the component (B4), and 74.0 parts by mass of Pre-1 as the component (B12) were used.

Example 7

A cured article and a polishing pad were produced and evaluated in the same manner as in Example 5 except that 13.4 parts by mass of the component (A-3), 5.4 parts by mass of MOCA as the component (B4), and 81.2 parts by mass of Pre-1 as the component (B12) were used.

Example 8

A cured article and a polishing pad were produced and evaluated in the same manner as in Example 5 except that 13.2 parts by mass of the component (A-4), 5.4 parts by mass of MOCA as the component (B4), and 81.4 parts by mass of Pre-1 as the component (B12) were used.

[Evaluation Method]

(1) Density

The density (g/cm$^3$) was measured with DSG-1, available from Toyo Seiki Seisaku-sho, Ltd.

(2) Hardness

The Shore D hardness was measured according to JIS K6253 (hardness test) with a durometer, available from Kobunshi Keiki Co., Ltd. The specimens were laminated to a thickness of 6 mm for the measurement. One having a relatively low hardness was measured for the Shore A hardness, and one having a relatively high hardness was measured for the Shore D hardness.

(3) Hysteresis Loss

The resin punched out to form a dumbbell No. 8 having a thickness of 2 mm was stretched by 20 mm at 10 mm/min with Autograph AG-SX, available from Shimadzu Corporation, and then the hysteresis loss was measured when recovery was performed until the stress becomes zero.

(4) Polishing Rate

The polishing rate in polishing was measured under the following condition. The polishing rate was the average value for 10 plies of 2-inch sapphire wafers.

- Slurry: Fujimi Compol 80 undiluted liquid

- Pressure: 4 psi
- Rotation number: 45 rpm
- Time: 1 hour

(5) Surface Roughness (Ra)

The surfaces of 10 plies of the 2-inch sapphire wafers polished under the condition shown in (4) above were measured for the surface roughness (Ra) with Nano Search Microscope SFT-4500 (available from Shimadzu Corporation). The surface roughness was the average value for 10 plies of the 2-inch sapphire wafers.

Comparative Examples 3 and 4

Cured articles and polishing pads were produced and evaluated in the same manner as in Example 5 except that the curable compositions having the compositions shown in Table 2 were used. The mixing ratios of the components and the results are shown in Table 2. Comparative Example 3 is an example using the ionic functional group-containing polyrotaxane monomer (RX-1) instead of the cyclic monomer A, and Comparative Example 4 is an example using the end hydroxy group-containing side chain cyclodextrin (pre-A) having no ionic functional group instead of the cyclic monomer A.

As shown by the results of Examples 5 to 8, the cured article obtained by curing the curable composition using the cyclic monomer having both a polymerizable functional group and an ionic functional group of the present invention showed a high polishing rate, and the surface roughness of the polishing target material was small. The curable compositions of Examples 5 to 8 were excellent in handleability, but the curable composition of Comparative Example 3 was poor in handleability. The cured article obtained by curing the curable composition of Comparative Example 4 had a lower polishing rate than Examples.

Table 2

| | Curable composition | | | Evaluation result | | | | |
|---|---|---|---|---|---|---|---|---|
| | Component (A) (part by mass) | Component (B) (part by mass) | (Other) components (part by mass) | Hysteresis loss (%) | Shore D hardness | Density (g/cm$^3$) | Polishing rate (pm/h) | Surface roughness Ra (nm) |
| Example 5 | A-1 (13.6) | Pre-1 (81.0)/ MOCA (5.4) | hollow particles 1 (0.8) | 35 | 25 | 0.8 | 4.5 | 0.24 |
| Example 6 | A-2 (20.3) | Pre-1 (74.0)/ MOCA (5.0) | hollow particles 1 (0.8) | 40 | 19 | 0.8 | 3.5 | 0.29 |
| Example 7 | A-3 (13.4) | Pre-1 (81.2)/ MOCA (5.4) | hollow particles 1 (0.8) | 36 | 25 | 0.8 | 4.3 | 0.26 |
| Example 8 | A-4 (13.2) | Pre-1 (81.4)/ MOCA (5.4) | hollow particles 1 (0.8) | 35 | 24 | 0.8 | 4.3 | 0.25 |
| Comparative Example 3 | - | RX-1 (26.4)/Pre-1 (68.8)/ MOCA (4.8) | hollow particles 1 (0.8) | 25 | 20 | 0.75 | 4.1 | 0.24 |
| Comparative Example 4 | - | Pre-A (12.0)/Pre-1 (82.5)/ MOCA (5.5) | hollow particles 1 (0.8) | 31 | 24 | 0.8 | 3.3 | 0.26 |

**Claims**

1. A curable composition comprising:

    (A) a cyclic monomer having both a polymerizable functional group and an ionic functional group in the molecule and
    (B) a polymerizable monomer having a polymerizable functional group capable of being polymerized with the polymerizable functional group of the cyclic monomer (A).

2. The curable composition according to claim 1, wherein

    the polymerizable functional group of the cyclic monomer (A) is at least one kind of group selected from the group consisting of a radical polymerizable group, an epoxy group, a hydroxy group, a thiol group, a primary amino group, and a secondary amino group, and
    the ionic functional group of the cyclic monomer (A) is a group capable of forming at least one kind of an ion selected from the group consisting of a carboxylate ion, a sulfonate ion, a phosphate ion, a phosphonate ion, and a quaternary ammonium cation.

3. The curable composition according to claim 1 or 2, wherein the cyclic monomer (A) has a proportion of the ionic functional group of 1% by mol or more and less than 90% by mol assuming that the total molar proportion of the polymerizable functional group and the ionic functional group is 100% by mol.

4. The curable composition according to any one of claims 1 to 3, wherein the cyclic monomer (A) comprises a cyclic molecule comprising a side chain, the side chain having the polymerizable functional group and the ionic functional group and introduced as a substituent of a hydroxy group of the cyclic molecule.

5. The curable composition according to any one of claims 1 to 4, wherein

    the polymerizable functional group of the cyclic monomer (A) is at least one kind of a group selected from the group consisting of a hydroxy group, a thiol group, a primary amino group, and a secondary amino group, and
    the polymerizable monomer (B) contains an iso(thio)cyanate compound (B 1) having at least an iso(thio)cyanate group in the molecule.

6. The curable composition according to claim 5, wherein the polymerizable functional group of the cyclic monomer (A) contains at least a hydroxy group, and

    the iso(thio)cyanate compound (B 1) contained in the polymerizable monomer (B) contains (B 12) a urethane prepolymer having iso(thio)cyanate groups on both end thereof, obtained through reaction of
    (B32) a bifunctional active hydrogen-containing compound having two active hydrogen-containing groups in the molecule, and
    (B13) a bifunctional polyiso(thio)cyanate compound having two iso(thio)cyanate groups in the molecule.

7. The curable composition according to claim 6, wherein the urethane prepolymer (B12) has an iso(thio)cyanate equivalent of 300 to 5,000.

8. The curable composition according to any one of claims 1 to 7, wherein the curable composition further contains (D) hollow particles having an outer shell part and a hollow part surrounded by the outer shell part, the outer shell part containing at least one kind of a resin selected from the group consisting of a urethane-based resin and a melamine resin.

9. A cured article obtained by curing the curable composition according to any one of claims 1 to 8.

10. A polishing pad comprising the cured article according to claim 9.

11.    (A) a cyclic monomer having both a polymerizable functional group and an ionic functional group in the molecule.

## INTERNATIONAL SEARCH REPORT

| | International application No. |
|---|---|
| | **PCT/JP2022/003132** |

**A. CLASSIFICATION OF SUBJECT MATTER**

*C08G 18/08*(2006.01)i; *C08G 18/10*(2006.01)i; *C08G 18/42*(2006.01)i; *B24B 37/24*(2012.01)i; *H01L 21/304*(2006.01)i
FI:   C08G18/08 004; C08G18/10; B24B37/24 C; H01L21/304 622F; C08G18/42 069

According to International Patent Classification (IPC) or to both national classification and IPC

**B. FIELDS SEARCHED**

Minimum documentation searched (classification system followed by classification symbols)

C08G18/08; C08G18/10; C08G18/42; B24B37/24; H01L21/304

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2021

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | WO 2020/096010 A1 (TOKUYAMA CORP.) 14 May 2020 (2020-05-14)<br>claims 1-12, paragraphs [0204]-[0241], examples 1-10 | 1-11 |
| X | JP 2019-56103 A (TORAY INDUSTRIES, INC.) 11 April 2019 (2019-04-11)<br>paragraphs [0064]-[0084], example 12 | 1-7, 9, 11 |
| A | | 8, 10 |

☐ Further documents are listed in the continuation of Box C.    ☑ See patent family annex.

| | | |
|---|---|---|
| * | Special categories of cited documents: | "T" later document published after the international filing date or priority date and not in conflict with the application but cited to understand the principle or theory underlying the invention |
| "A" | document defining the general state of the art which is not considered to be of particular relevance | |
| "E" | earlier application or patent but published on or after the international filing date | "X" document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | |
| "P" | document published prior to the international filing date but later than the priority date claimed | "&" document member of the same patent family |

| Date of the actual completion of the international search | Date of mailing of the international search report |
|---|---|
| **25 February 2022** | **08 March 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**
**Information on patent family members**

International application No.

**PCT/JP2022/003132**

| Patent document cited in search report | | | Publication date (day/month/year) | Patent family member(s) | Publication date (day/month/year) |
|---|---|---|---|---|---|
| WO | 2020/096010 | A1 | 14 May 2020 | (Family: none) | |
| JP | 2019-56103 | A | 11 April 2019 | (Family: none) | |

Form PCT/ISA/210 (patent family annex) (January 2015)

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2007077207 A
- JP 2007276061 A
- WO 2020096010 A
- WO 2015159875 A

- WO 2015068798 A
- WO 2016143910 A
- JP 2017048305 A
- WO 2014136804 A